# EUROPEAN PATENT SPECIFICATION

(11) **EP 3 783 345 B1**
(45) Date of publication and mention of the grant of the patent: **01.11.2023**
(21) Application number: 19867276.8
(22) Date of filing: 27.09.2019
(51) Int. Cl.: G01R 33/38, G01N 24/00, H01F 6/00, H01F 5/00, G01R 33/3815, H01F 6/04

(54) **MAGNET UNIT FOR NUCLEAR MAGNETIC RESONANCE AND MAGNETIC FIELD GENERATING DEVICE FOR NUCLEAR MAGNETIC RESONANCE**
KERNSPINRESONANZMAGNETEINHEIT UND KERNSPINRESONANZMAGNETFELDERZEUGUNGSVORRICHTUNG
UNITÉ D'AIMANT DE RÉSONANCE MAGNÉTIQUE NUCLÉAIRE ET DISPOSITIF DE GÉNÉRATION DE CHAMP MAGNÉTIQUE DE RÉSONANCE MAGNÉTIQUE NUCLÉAIRE

(30) Priority: 28.09.2018 JP 2018184892
(43) Date of publication of application: 24.02.2021
(73) Proprietor: NIPPON STEEL CORPORATION, Chiyoda-ku Tokyo 100-8071 (JP)
(72) Inventor: MORITA, Mitsuru, Tokyo 100-8071 (JP)
(74) Representative: Vossius & Partner Patentanwälte Rechtsanwälte mbB
(86) International application number: PCT/JP2019/038234
(87) International publication number: WO 2020/067458

(56) References cited:
- WO-A1-2018/021507
- JP-A- H08 168 476
- JP-A- 2016 006 825
- JP-A- 2017 529 201
- JP-A- 2018 018 924
- JP-A- 2018 018 924
- US-A1- 2018 012 690
- US-B2- 7 498 810
- HUANG CHEN-GUANG ET AL: "Mechanical improvement of metal reinforcement rings for a finite ring-shaped superconducting bulk", AIP ADVANCES, AMERICAN INSTITUTE OF PHYSICS, 2 HUNTINGTON QUADRANGLE, MELVILLE, NY 11747, vol. 8, no. 3, 28 March 2018 (2018-03-28), XP012227368, DOI: 10.1063/1.5020237 [retrieved on 2018-03-28]

## Description

### [Technical Field of the Invention]

The present invention relates to a magnet unit for nuclear magnetic resonance and a magnetic field generating device for nuclear magnetic resonance.

### [Related Art]

A nuclear magnetic resonance (NMR) apparatus (hereinafter, also referred to as "NMR apparatus") is an analyzer used to obtain information such as the molecular structure and physical/chemical properties of a sample by generating a strong magnetic field, irradiating the sample disposed in the strong magnetic field with an electromagnetic wave to cause the nuclear spins of atomic nuclei in the sample to resonate, and detecting the energy absorbed by the sample during the resonance as an NMR signal.

As a superconducting magnet that is a magnetic field generating source of the NMR apparatus, an oxide superconducting bulk body obtained by forming a single-crystal oxide superconducting material into a bulk may be used. The oxide superconducting material has a high critical current density. Therefore, the oxide superconducting bulk body becomes an oxide superconducting bulk magnet capable of generating a strong magnetic field by capturing an external magnetic field.

To magnetize a single-crystal oxide superconducting bulk body having a general size (for example, a diameter of about 40 to 100 mm) with a high-strength magnetic field and generate a strong magnetic field from the magnetized oxide superconducting bulk body, it is effective to process a plurality of oxide superconducting bulk bodies into a ring shape and stack the plurality of ring-shaped oxide superconducting bulk bodies in a central axis direction.

For example, in a case where the oxide superconducting bulk magnet is applied to a small NMR apparatus or a small MRI apparatus, about six to eight ring-shaped oxide superconducting bulk bodies having an outer diameter of 60 mm and a height of about 20 mm are stacked in a direction along the central axis of the oxide superconducting bulk bodies to manufacture a stacked body. There is a technique in which this stacked body is magnetized to be applied as an oxide superconducting bulk magnet to a small NMR apparatus or a small MRI apparatus. It is said that by using the above oxide superconducting bulk magnet in a small NMR apparatus or a small MRI apparatus, a strong and uniform magnetic field is formed in the central part of the oxide superconducting bulk magnet, and a good signal can be obtained.

The oxide superconducting bulk magnet has a feature capable of generating a significantly strong magnetic field in a narrow space. However, when the oxide superconducting bulk body captures a strong external magnetic field, electromagnetic stress (hoop stress) that acts on the captured magnetic field to spread acts on the oxide superconducting bulk body. Since the oxide superconducting bulk body captures a strong magnetic field with a small volume, a large hoop stress acts. For example, in a case where the oxide superconducting bulk body captures an external magnetic field of 5 T to 10 T, there is a possibility that the electromagnetic stress acting on the oxide superconducting bulk body may exceed the strength of the oxide superconducting bulk body itself and the oxide superconducting bulk body may be damaged.

In addition, in a case of magnetizing oxide superconducting bulk units formed by stacking ring-shaped oxide superconducting bulk bodies in a central axis direction, in a oxide superconducting bulk unit in which the ratio of the length in the central axis direction (stacking height) to the outer diameter is small, stress in the vicinity of the edge portion of the inner circumferential surface of the oxide superconducting bulk unit is about the same as stress at a position away from the edge portion of the inner circumferential surface of the oxide superconducting bulk unit. On the other hand, in an oxide superconducting bulk unit in which the ratio of the stacking height to the outer diameter is large, electromagnetic stress concentrates on the edge portion of the inner circumferential surface of the oxide superconducting bulk unit. Therefore, large strain and cracking are likely to occur at the edge portion of the inner circumferential surface of the oxide superconducting bulk unit.

In order to prevent cracking of the oxide superconducting bulk body during magnetization, an external magnetic field applied to the oxide superconducting bulk body may be lowered, and as a result, there may be cases where the oxide superconducting bulk magnet, which is the oxide superconducting bulk body after being magnetized, cannot generate a strong magnetic field. Therefore, technical development for preventing damage to the oxide superconducting bulk body in a case of magnetizing the oxide superconducting bulk body with a strong magnetic field is under way.

For example, Patent Document 1 discloses a superconducting bulk magnet including a columnar oxide superconducting bulk body and a metal ring surrounding the oxide superconducting bulk body.

For example, Patent Document 2 discloses a superconducting magnetic field generating element in which seven hexagonal columnar oxide superconducting bulk bodies are assembled, a support member made of a fiber-reinforced resin or the like is disposed around the seven oxide superconducting bulk bodies, a support member made of metal such as stainless steel or aluminum is further disposed on the outer circumference of the support member.

For example, Patent Document 3 discloses an oxide superconducting bulk magnet in which at least a part of a side surface and an upper surface or at least a part of upper and lower surfaces of an oxide superconducting bulk body is reinforced.

For example, Patent Document 4 discloses a superconducting bulk magnet in which a plurality of ring-shaped superconducting bulk bodies whose outer circumference and inner circumference are reinforced are stacked.

For example, Patent Document 5 discloses a superconducting bulk magnet including a plurality of ring-shaped oxide superconducting bulk bodies, a ring-shaped support member, and an outer circumferential reinforcing ring, in which the outer circumferential reinforcing ring is provided on the outer circumference of a stacked body in which the ring-shaped oxide superconducting bulk bodies and the ring-shaped support member are stacked.

Furthermore, for example, in Non-Patent Document 1, in oxide superconducting bulk units which are configured by stacking ring-shaped oxide superconducting bulk bodies and are reinforced differently, the result of a simulation test of electromagnetic stress generated in the oxide superconducting bulk units when being subjected to an external magnetic field and cooled is disclosed. In Non-Patent Document 1, it is shown that by reinforcing the outer circumferential surface, the end surface perpendicular to the central axis, and the inner circumferential surface of the oxide superconducting bulk body located at the end portion of the oxide superconducting bulk unit in the oxide superconducting bulk unit, electromagnetic stress can be reduced and cracking of the oxide superconducting bulk unit can be suppressed.

An NMR apparatus is expected to have high performance, smaller size, and lighter weight as long as damage to the oxide superconducting bulk body due to electromagnetic stress can be prevented.

Therefore, in recent years, technical development for a magnet member of a small NMR apparatus or a small magnetic resonance imaging (MRI) apparatus, a drug delivery system using magnetic force, and the like, which utilize the feature of an oxide superconducting bulk magnet that is compact and capable of generating a strong magnetic field, is underway.

For example, Patent Document 6 discloses a compact NMR apparatus in which an oxide superconducting bulk unit is magnetized and used as a superconducting bulk magnet.

For example, Patent Document 7 discloses an NMR apparatus in which a superconducting tape wire rod is used as a part of an oxide superconducting bulk unit to generate a uniform magnetic field in a hollow portion.

For example, Non-Patent Document 2 introduces the state of development of a small magnet unit for NMR using various ring-shaped oxide superconducting bulk bodies.

For example, Patent Document 8 discloses a bulk magnet structure including a plurality of superconducting bulk bodies and at least one outer circumferential reinforcing ring fitted so as to cover the outer circumferential surfaces of the plurality of stacked superconducting bulk bodies.

### [Prior Art Document]

### [Patent Document]

[Patent Document 1] Japanese Unexamined Patent Application, First Publication No. H11-335120
[Patent Document 2] Japanese Unexamined Patent Application, First Publication No. H11-284238
[Patent Document 3] Japanese Unexamined Patent Application, First Publication No. 2014-146760
[Patent Document 4] Japanese Unexamined Patent Application, First Publication No. 2014-75522
[Patent Document 5] PCT International Publication No. WO2016/117658
[Patent Document 6] Japanese Unexamined Patent Application, First Publication No. 2002-6021
[Patent Document 7] Japanese Unexamined Patent Application, First Publication No. 2016-6825
[Patent Document 8] Japanese Unexamined Patent Application, First Publication No. 2018-18924

### [Non-patent document]

[Non-Patent Document 1] H. Fujishiro, et al., "New proposal of mechanical reinforcement structures to annular REBaCuO bulk magnet for compact and cryogen-free NMR spectrometer", Physica C: Superconductivity and its Applications, 550 (2018), p52-56
[Non-Patent Document 2] Takashi Nakamura et al., "Special edition: Development of Cylindrical Superconducting Bulk Magnet for a Compact NMR Spectrometer and Its Signal Detection", TEION KOGAKU, Cryogenics and Superconductivity Society of Japan, January 2017, Vol. 52, No. 1, p.3-43

### [Disclosure of the Invention]

### [Problems to be Solved by the Invention]

In the techniques described in Patent Document 1, Patent Document 2, and Patent Document 3, the uniformity of the magnetic field formed inside the oxide superconducting bulk body is insufficient, and there is room for improvement.

In the techniques described in Patent Document 4 and Patent Document 5, in a case where the ratio of the stacking height to the outer diameter in the oxide superconducting bulk unit is large, the strain amount in the vicinity of the edge portion of the inner circumferential surface of the oxide superconducting bulk unit becomes extremely large compared to the strain amount in the vicinity of the inner circumferential surface of the oxide superconducting bulk unit other than the edge portion. Therefore, for example, when the oxide superconducting bulk unit is magnetized with a strong magnetic field of about 6 to 10 T, there is a possibility that the oxide superconducting bulk unit may be damaged in the vicinity of the edge portion of the inner circumferential surface of the oxide superconducting bulk unit, so that it is difficult to stably magnetize the oxide superconducting bulk unit.

In the simulation test in Non-Patent Document 1, it is assumed that the oxide superconducting bulk body and a metal ring are firmly fixed. However, in a case of a test using an actual object, the pressing force between the oxide superconducting bulk body and the metal ring disposed on the inner circumferential surface of the oxide superconducting bulk body is not always applied. There is a possibility that the oxide superconducting bulk body and the metal ring may peel away from each other in the vicinity of the interface therebetween under the force generated between the oxide superconductor and the metal ring during cooling due to the difference between the thermal contraction rate of the oxide superconducting bulk body and the thermal contraction rate of the metal ring. As described above, since the boundary condition assumed in the simulation test may not be satisfied in an actual situation, even if the actual oxide superconducting bulk unit is reinforced based on the result of the simulation test described in Non-Patent Document 1, a sufficient effect is not obtained.

Since the superconductor used in the NMR apparatus described in Patent Document 6, Patent Document 7, and Non-Patent Document 2 is not sufficiently reinforced, there may be cases where it is difficult to capture a high-strength magnetic field in this high-temperature superconductor.

In the bulk magnet structure described in Patent Document 8 in which a plurality of bulk bodies having the same outer diameter are used, there is room for improvement in durability of the bulk bodies.

Therefore, the present invention has been made in view of the above problems, and an object of the present invention is to provide a magnet unit for nuclear magnetic resonance and a magnetic field generating device for nuclear magnetic resonance capable of generating a high-strength magnetic field by preventing damage to superconducting bulk bodies.

### [Means for Solving the Problem]

In order to solve the above problems, the present inventors intensively studied, as a result, found that, in a stacked body in which a plurality of ring-shaped oxide superconducting bulk bodies are stacked in a central axis direction, by setting the outer diameter, thickness, or volume of the oxide superconducting bulk body located at one end or both ends in the stacking direction to be smaller than the outer diameter, thickness, or volume of the oxide superconducting bulk body adjacent to the oxide superconducting bulk body, concentration of electromagnetic stress generated at the edge portion of the inner circumferential surface can be relaxed, and as a result of further investigation, achieved the present invention. Unlike a method in the related art in which the edge portion of the inner circumferential surface of an oxide superconducting bulk unit is mechanically reinforced, the present invention makes it possible to prevent cracking by relaxing the electromagnetic stress concentrated on the edge portion.

The gist of the present invention completed based on the above findings is as follows.
(1) A magnet unit for nuclear magnetic resonance according to a first aspect of the present invention, includes: a plurality of ring-shaped oxide superconducting bulk bodies having a structure in which a RE₂BaCuO₅ phase is dispersed in a single-crystal REBa₂Cu₃O_{y} phase (RE is one or two or more elements selected from rare earth elements, and y satisfies 6.8 ≤ y ≤ 7.1), in which the plurality of oxide superconducting bulk bodies are coaxially stacked in a coaxial direction to form a stacked body, and the plurality of oxide superconducting bulk bodies include a first oxide superconducting bulk body disposed at one end or both ends of the stacked body, and a second oxide superconducting bulk body adjacent to the first oxide superconducting bulk body, and satisfy at least any one of the following conditions of A), B), A) and B), A) and C), B) and C), and A), B) and C):
   (A) An outer diameter of the first oxide superconducting bulk body is smaller than an outer diameter of the second oxide superconducting bulk body.
   (B) A radial thickness of the first oxide superconducting bulk body is smaller than a radial thickness of the second oxide superconducting bulk body.
   (C) A volume of the first oxide superconducting bulk body is smaller than a volume of the second oxide superconducting bulk body.
(2) In the aspect according to (1), the first oxide superconducting bulk body may satisfy all the conditions of (A) to (C).
(3) In the aspect according to (1) or (2), a support member provided at least on an outer circumferential surface side of the first oxide superconducting bulk body and on an outer circumferential surface side of the second oxide superconducting bulk body is further included, in which a thickness of a portion of the support member located on the outer circumferential surface side of the first oxide superconducting bulk body may be larger than a thickness of a portion of the support member located on the outer circumferential surface side of the second oxide superconducting bulk body.
(4) In the aspect according to (3), the support member may extend so as to cover at least a part of an outer surface side end surface of the first oxide superconducting bulk body.
(5) In the aspect according to any one of (1) to (4), an inner diameter of the first oxide superconducting bulk body may be 80% or more and 140% or less of an inner diameter of the second oxide superconducting bulk body.
(6) In the aspect according to any one of (1) to (5), a corner portion formed by an outer surface side end surface and an inner circumferential surface of the first oxide superconducting bulk body may be chamfered.
(7) In the aspect according to any one of (1) to (6), a plate-shaped oxide superconducting bulk body having the structure may be disposed at the other end opposite to the one end where the first oxide superconducting bulk body of the stacked body is disposed.
(8) A magnetic field generating device for nuclear magnetic resonance according to a second aspect of the present invention includes: the magnet unit for nuclear magnetic resonance according to (7); and a cooling device having a low temperature portion, in which the plate-shaped oxide superconducting bulk body is connected to the low temperature portion.

### [Effects of the Invention]

According to the present invention, it is possible to provide the magnet unit for nuclear magnetic resonance and the magnetic field generating device for nuclear magnetic resonance capable of preventing damage to the superconducting bulk body and generating a magnetic field of higher strength.

### [Brief Description of the Drawings]

FIG. 1 is a partial cross-sectional view showing an example of a schematic configuration of a nuclear magnetic resonance apparatus to which a magnet unit for nuclear magnetic resonance and a magnetic field generating device for nuclear magnetic resonance according to an embodiment of the present invention can be applied.
FIG. 2 is a cross-sectional view of the magnet unit according to the embodiment taken along a plane including a central axis.
FIG. 3 is a cross-sectional view of a magnet unit for nuclear magnetic resonance showing an example of a stacked state of oxide superconducting bulk bodies according to the embodiment.
FIG. 4 is a cross-sectional view of a magnet unit for nuclear magnetic resonance showing another example of the magnet unit for nuclear magnetic resonance according to the embodiment.
FIG. 5 is a cross-sectional view of a magnet unit for nuclear magnetic resonance showing another example of the magnet unit for nuclear magnetic resonance according to the embodiment.
FIG. 6 is a cross-sectional view of a magnet unit for nuclear magnetic resonance showing another example of the magnet unit for nuclear magnetic resonance according to the embodiment.
FIG. 7 is a cross-sectional view of a magnet unit for nuclear magnetic resonance showing a modification example of the magnet unit for nuclear magnetic resonance according to the embodiment.
FIG. 8 is a cross-sectional view showing an example of the magnet unit for nuclear magnetic resonance according to the embodiment placed on a cold head.
FIG. 9A is a schematic diagram showing a distribution of a superconducting current in a cross section of a magnet unit in the related art after being magnetized.
FIG. 9B is a schematic diagram showing a magnetic field distribution in a case where the superconducting current flows as shown in FIG. 9A.
FIG. 9C is a schematic diagram showing a stress distribution in FIG. 9B.
FIG. 9D is a schematic diagram showing a magnetic field distribution in a case where a superconducting current flows in a magnet unit according to an embodiment of the present invention.
FIG. 9E is a schematic diagram showing a stress distribution in FIG. 9D.
FIG. 10A is a schematic diagram showing a distribution of a superconducting current in a cross section of a magnet unit according to an embodiment of the present invention after being magnetized.
FIG. 10B is a schematic diagram showing a magnetic field distribution in a case where the superconducting current flows as shown in FIG. 10A.
FIG. 11A is a schematic diagram showing a distribution of a superconducting current in a cross section of a magnet unit according to an embodiment of the present invention after being magnetized.
FIG. 11B is a schematic diagram showing a magnetic field distribution in a case where the superconducting current flows as shown in FIG. 11A.
FIG. 12A is a schematic diagram showing a distribution of a superconducting current in a cross section of a magnet unit according to an embodiment of the present invention after being magnetized.
FIG. 12B is a schematic diagram showing a magnetic field distribution in a case where the superconducting current flows as shown in FIG. 12A.
FIG. 13A is a schematic diagram showing a distribution of a superconducting current in a cross section of a magnet unit according to an embodiment of the present invention after being magnetized.
FIG. 13B is a schematic diagram showing a magnetic field distribution in a case where the superconducting current flows as shown in FIG. 13A.

### [Embodiments of the Invention]

Hereinafter, preferred embodiments of the present invention will be described in detail with reference to the accompanying drawings. In the present specification and the drawings, like constituent elements having substantially the same functional configuration are denoted by like reference numerals, and overlapping description will be omitted. Furthermore, the ratios and dimensions of the respective constituent elements in the drawings do not represent the actual ratios and dimensions of the respective constituent elements.

### <1. NMR Apparatus 1>

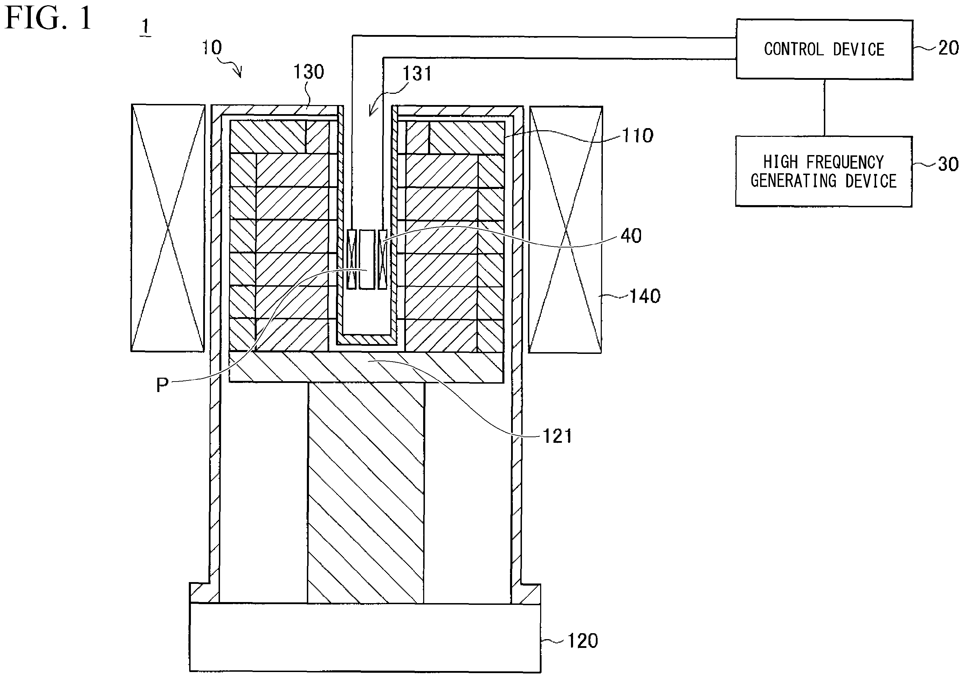

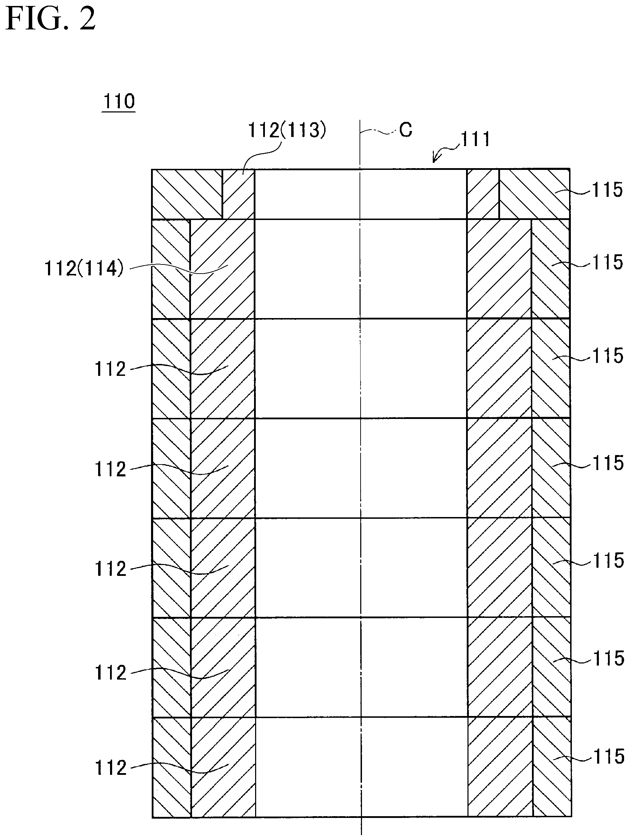

First, an NMR apparatus 1 to which a magnet unit for NMR according to an embodiment of the present invention and a magnetic field generating device for NMR according to the embodiment of the present invention can be applied will be described with reference to FIGS. 1 and 2. FIG. 1 is a partial cross-sectional view showing an example of a schematic configuration of a nuclear magnetic resonance apparatus to which a magnet unit for nuclear magnetic resonance and a magnetic field generating device for nuclear magnetic resonance according to the embodiment of the present invention can be applied. FIG. 2 is a cross-sectional view of the magnet unit according to the present embodiment taken along a plane including a central axis.

The NMR apparatus to which the magnet unit for NMR and the magnetic field generating device for NMR according to the present embodiment are applied is not limited to the NMR apparatus 1 described here.

The NMR apparatus 1 is an analyzer used to obtain information such as the molecular structure and physical/chemical properties of a sample by irradiating the sample disposed in a magnetic field with an electromagnetic wave to cause the nuclear spins of atomic nuclei in the sample to resonate, and detecting the energy absorbed during the resonance as an NMR signal. As shown in FIG. 1, the NMR apparatus 1 includes a magnetic field generating device 10, a control device 20, a high frequency generating device 30, and a detecting coil 40. The magnetic field generating device 10 relates to the embodiment of the magnetic field generating device for NMR according to the present invention.

The magnetic field generating device 10 generates a magnetic field used for NMR analysis. The magnetic field generating device 10 includes a magnet unit 110, a cooling device 120, a heat insulating container 130, and a magnetic field generating coil 140.

The magnet unit 110 functions as a superconducting magnet by capturing a high-strength external magnetic field, and forms a magnetic field for NMR analysis in the bore space of the NMR apparatus. Although the details will be described later, the magnet unit 110 includes a plurality of ring-shaped oxide superconducting bulk bodies 112 having a structure in which a RE₂BaCuO₅ phase is dispersed in a single-crystal REBa₂Cu₃O_{y} phase (RE is one or two or more elements selected from rare earth elements, and y satisfies 6.8 ≤ y ≤ 7.1), as shown in FIG. 2. The magnet unit 110 includes a stacked body 111 formed by coaxially stacking the plurality of oxide superconducting bulk bodies 112 in the coaxial direction.

The plurality of oxide superconducting bulk bodies 112 include a first oxide superconducting bulk body 113 disposed at one end or both ends of the stacked body and a second oxide superconducting bulk body 114 adjacent to the first oxide superconducting bulk body 113, and satisfy at least any one of the following conditions of A, B, A) and B), A) and C), B) and C), and A), B) and C):
(A) The outer diameter of the first oxide superconducting bulk body is smaller than the outer diameter of the second oxide superconducting bulk body.
(B) The radial thickness of the first oxide superconducting bulk body is smaller than the radial thickness of the second oxide superconducting bulk body.
(C) The volume of the first oxide superconducting bulk body is smaller than the volume of the second oxide superconducting bulk body.

Accordingly, the magnet unit 110 is prevented from being damaged, and can generate a magnetic field of higher strength. The "radial thickness" is the radial length of the oxide superconducting bulk bodies 113 and 114. FIG. 2 shows a case where the outer diameter of the oxide superconducting bulk body 113 (first oxide superconducting bulk body) is smaller than the outer diameter of the oxide superconducting bulk body 114 (second oxide superconducting bulk body) adjacent to the oxide superconducting bulk body 113. The magnet unit 110 relates to an aspect of the magnet unit for NMR according to the present invention. The magnet unit 110 includes support members 115, which will be described later, as necessary.

The magnet unit 110 is disposed in the heat insulating container 130 while being placed on a cold head (low temperature portion) 121 of the cooling device 120. That is, the magnet unit 110 is disposed adjacent to the cold head 121. Accordingly, the magnet unit 110 is thermally connected to the cold head 121 and can be cooled by the cooling device 120.

The low temperature portion of the cooling device 120 means a part including the cold head 121 that is cooled to a low temperature with respect to room temperature. The cooling device 120 cools the magnet unit 110 via the cold head 121. The cooling device 120 is not particularly limited as long as it can cool the magnet unit 110 to a temperature equal to or lower than a superconducting transition temperature Tc of the oxide superconducting bulk bodies constituting the magnet unit 110. For example, a cooling medium such as liquid helium or liquid neon, a Gifford-McMahon (GM) cooler, a pulse tube refrigerator, or the like can be used. The cooling device 120 is controlled by a temperature control device (not shown).

The heat insulating container 130 accommodates the magnet unit 110 and the cold head 121, and suppresses heat transfer from the outside of the heat insulating container 130 to the magnet unit 110. The heat insulating container 130 accommodates the magnet unit 110 and the cold head 121, for example, as shown in FIG. 1. The heat insulating container 130 has, for example, a recessed part 131 formed from the upper surface thereof toward a hollow portion of the magnet unit 110 accommodated in the container. An analysis sample P and the detecting coil 40 are disposed in the recessed part 131. As the material of the heat insulating container 130, for example, a non-magnetic material can be used. Specifically, aluminum, an aluminum alloy, austenitic stainless steel, or the like can be used.

The magnetic field generating coil 140 applies a magnetic field to the magnet unit 110. For example, the magnetic field generating coil 140 is provided so as to surround the magnet unit 110. By energizing the magnetic field generating coil 140, a magnetic field (application magnetic field) is generated, and the magnetic field is applied to the magnet unit 110.

As the magnetic field generating coil 140, for example, a metal-based low temperature superconductor, an oxide-based superconductor, or an iron-based superconductor can be used. As the metal-based low-temperature superconductor, for example, a niobium-titanium alloy or a niobium-tin alloy can be used. As the oxide-based superconductor, for example, a bismuth-based superconductor or an RE-based superconductor can be used.

The control device 20 controls irradiation of the analysis sample P with an electromagnetic wave, converts a signal current flowing in the detecting coil 40 into an NMR signal by nuclear magnetic resonance generated by the irradiation of the electromagnetic wave, amplifies the NMR signal, and generates an NMR spectrum based on the amplified NMR signal.

The high frequency generating device 30 generates a high frequency pulse and irradiates the analysis sample P with a pulsed electromagnetic wave from the detecting coil 40.

The detecting coil 40 is disposed in the recessed part 131 of the heat insulating container 130. The analysis sample P is disposed on the central axis side of the detecting coil 40. The detecting coil 40 energizes the high frequency pulse generated by the high frequency generating device 30, and irradiates the analysis sample P with the pulsed electromagnetic wave. When the analysis sample P disposed in the magnetic field generated by the magnet unit 110 is irradiated with the pulsed electromagnetic wave, nuclear magnetic resonance occurs, and a signal current corresponding to the structure of the analysis sample P flows through the detecting coil 40. The detecting coil 40 transmits this signal current to the control device 20.

Here, an operation of the NMR apparatus 1 will be briefly described. The operation of the NMR apparatus 1 includes a magnetizing step of magnetizing the magnet unit 110 and an analyzing step of analyzing the sample using the magnetic field generated by the magnetized magnet unit 110.

In the magnetizing step, a current is passed through the magnetic field generating coil 140 to generate an application magnetic field, and the magnetic field strength is increased until a predetermined magnetic field strength is reached. After the application magnetic field having a predetermined strength is generated, the cooling device 120 cools the magnet unit 110 to a predetermined temperature (magnetization temperature) equal to or lower than the superconducting transition temperature (Tc). After the magnet unit 110 is cooled to the magnetization temperature, the application magnetic field of the magnetic field generating coil 140 is gradually reduced, and energization of the magnetic field generating coil 140 is finally stopped to eliminate the application magnetic field. Accordingly, the magnet unit 110 is magnetized with the application magnetic field.

Before the completion of magnetization, it is preferable to further lower the temperature of the magnet unit 110 from the magnetization temperature to a predetermined temperature by using the cooling device 120. By lowering the temperature of the magnet unit 110 to lower than the magnetization temperature before the end of the magnetizing step, it is possible to suppress flux creep in which the magnetic flux captured by the magnet unit 110 is reduced, and to stabilize a magnetic field distribution copied to the magnet unit 110.

The magnetic field generated by the magnet unit 110 has a total magnetic flux amount sufficient for NMR analysis, and has excellent uniformity in the recessed part 131.

In the analyzing step, the analysis sample P is disposed in the recessed part 131 having a uniform and high-strength magnetic field distribution. Next, the high frequency generating device 30 is operated to generate a high frequency pulse, and the detecting coil 40 irradiates the analysis sample P with a pulsed electromagnetic wave. Then, nuclear magnetic resonance occurs, and a signal current corresponding to the structure of the analysis sample P flows in the detecting coil 40. The control device 20 converts this signal current into an NMR signal and amplifies the NMR signal to generate an NMR spectrum. Then, a user analyzes the structure of the analysis sample P from the NMR spectrum. Hereinabove, the NMR apparatus 1 in which the magnet unit for NMR and the magnetic field generating device for NMR according to the embodiment of the present invention can be used has been described.

### <2. Magnet Unit 110>

Next, the magnet unit 110 according to the present embodiment will be described with reference to FIG. 2.

As described above, the magnet unit 110 includes the plurality of oxide superconducting bulk bodies 112. The magnet unit 110 includes the support members 115 as necessary.

Here, an oxide superconducting bulk material forming the oxide superconducting bulk body 112 will be described. The oxide superconducting bulk material has a structure in which a RE₂BaCuO₅ phase (211 phase) that is a non-superconducting phase is dispersed in a single-crystal REBa₂Cu₃O_{y} phase (123 phase). Here, RE is one or two or more elements selected from rare earth elements, and y satisfies 6.8 ≤ y < 7.1. The structure in which the 211 phase is finely dispersed in the single-crystal 123 phase is called a so-called QMG (registered trademark) material. RE forming the 123 phase and the 211 phase includes, for example, one or two or more elements selected from the group consisting of Y, La, Nd, Sm, Eu, Gd, Dy, Ho, Er, Tm, Yb, and Lu. In addition, RE forming the 123 phase and RE forming the 211 phase may be elements different from each other. However, there may be cases where the 123 phase containing at least any of La, Nd, Sm, Eu, and Gd deviates from the stoichiometric composition of RE:Ba:Cu=1:2:3, and a portion of RE present the position (RE site) where RE is disposed is substituted with Ba. In addition, it is known that even in the 211 phase that is a non-superconducting phase, there may be cases where La and Nd are different from Y, Sm, Eu, Gd, Dy, Ho, Er, Tm, Yb, and Lu and the ratio of metal elements constituting the 211 phase is a non-stoichiometric composition, and the crystal structure of the 211 phase is different. The term "single crystal" mentioned here does not mean only a perfect single crystal, but also includes a single crystal in which a defect that does not interfere with practical use, such as a small angle grain boundary, is present.

The above-mentioned substitution of RE with Ba tends to lower the critical temperature of the oxide superconducting bulk material. In addition, in an environment with a smaller oxygen partial pressure, substitution of RE with Ba tends to be suppressed.

The 123 phase is generated by a peritectic reaction between the 211 phase and a liquid phase formed of a composite oxide of Ba and Cu as shown below.

211 phase + liquid phase (composite oxide of Ba and Cu) → 123 phase

A generation temperature T_{f}, which is the temperature at which the 123 phase is generated by this peritectic reaction, is substantially related to the ionic radius of the RE element, and the generation temperature Tε decreases as RE having a smaller ionic radius is contained. Moreover, the lower the oxygen partial pressure during the peritectic reaction, the lower the generation temperature Tε. When Ag is further contained as an element included in the 123 phase and the 211 phase, the generation temperature Tε tends to decrease.

The structure in which the 211 phase is finely dispersed in the single-crystal 123 phase can be formed because particles of the unreacted 211 phase are left in the 123 phase when crystal growth of the 123 phase proceeds. That is, the oxide superconducting bulk material is generated by the following reaction.

211 phase + liquid phase (composite oxide of Ba and Cu) → 123 phase + 211 phase

The fine dispersion of the 211 phase in the 123 phase is extremely important from the viewpoint of improving a critical current density J_{c}. By using at least any of Pt, Rh, and Ce as one of the raw materials in addition to the above-mentioned elements, grain growth of the 211 phase is suppressed in a semi-molten state (state including the 211 phase and the liquid phase). As a result, the 211 phase having a particle size of about 1 µm is dispersed in the oxide superconducting bulk material. It is preferable that at least any one element of Pt, Rh, and Ce is contained in an amount that exhibits a refining effect. The amount of Pt, Rh, or Ce is preferably determined in consideration of material cost. The amount of Pt is preferably 0.2 mass% or more and 2.0 mass% or less, and more preferably 0.4 mass% or more and 0.8 mass% or less, with respect to the mass of the oxide superconducting bulk material. The amount of Rh is preferably 0.01 mass% or more and 0.5 mass% or less, and more preferably 0.05 mass% or more and 0.4 mass% or less, with respect to the mass of the oxide superconducting bulk material. The amount of Ce is preferably 0.5 mass% or more and 2.0 mass% or less, and more preferably 1.0 mass% or more and 1.5 mass% or less, with respect to the mass of the oxide superconducting bulk material. In a case of using a plurality of elements among Pt, Rh, and Ce, the total amount of Pt, Rh, and Ce contained is preferably 0.1 mass% or more and 2.0 mass% or less, and more preferably 0.2 mass% or more and 1.5 mass% or less, with respect to the mass of the oxide superconducting bulk material. In the oxide superconducting bulk material in which the 211 phase is finely dispersed in the 123 phase, some of Pt, Rh, and Ce is solid-solutilized in the 123 phase, and the residue among Pt, Rh, and Ce that has not been solid-solutilized in the 123 phase forms a composite oxide with Ba or Cu and is scattered in the oxide superconducting bulk material.

In order for the oxide superconducting bulk material to function as a superconducting magnet, the oxide superconducting bulk material needs to have a high critical current density (Jc) in a magnetic field. In order for the oxide superconducting bulk material to have a high critical current density in a magnetic field, the 123 phase needs to be in a single crystal form that does not include a large angle grain boundary that causes a superconducting weak bond. In order to have higher Jc characteristics, a pinning center for stopping a magnetic flux movement is required. The 211 phase that is finely dispersed functions as this pinning center. It is preferable that a large number of the 211 phases are more finely dispersed. As described above, Pt, Rh, and Ce have an action of promoting the refinement of the 211 phase. In addition, the non-superconducting phase such as the 211 phase is finely dispersed in the 123 phase which is easily cleaved, thereby mechanically strengthening the superconductor and also playing an important role as a bulk material. It is known that compounds such as BaCeO₃, BaSiO₃, BaGeO₃, and BaSnO₃ may function as pinning centers. Therefore, the oxide superconducting bulk material may contain one or two or more selected from BaCeO₃, BaSiO₃, BaGeO₃, and BaSnOs.

Here, the ratio of the 211 phase to the 123 phase in the oxide superconducting bulk material is preferably 5 volume% or more and 35 volume% or less, and more preferably 15 volume% or more and 30 volume% or less from the viewpoint of the characteristics of the critical current density (J_{c}) and mechanical strength. Furthermore, the oxide superconducting bulk material may further contain Ag in addition to the above-mentioned elements. In a case where the oxide superconducting bulk material contains Ag, the oxide superconducting bulk material contains Ag or an Ag compound having a particle size of, for example, about 1 to 500 µm in an amount of more than 0 volume% and 25 volume% or less, depending on the Ag content.

In the oxide superconducting bulk material, about 5 to 20 volume% of voids (bubbles) of about 50 to 500 µm are generally present.

The oxide superconducting bulk material is manufactured by using a seed crystal of the 123 phase and growing the 123 phase as a single crystal in a state of controlling the crystal orientation. The crystal growth rate depends on the temperature conditions, and the crystal growth rate increases in a case where the difference between the generation temperature Tε and the ambient temperature during crystal growth is large. However, in a case where the difference between the generation temperature Tε and the ambient temperature during crystal growth is large, the 123 phase is likely to become polycrystalline. In a case of manufacturing a large single-crystal oxide superconducting bulk material, it is important to grow a crystal while suppressing polycrystallization. Therefore, in general, as the size of the single-crystal oxide superconducting bulk material to be manufactured increases, it becomes more difficult to manufacture the single-crystal oxide superconducting bulk material.

In order for the oxide superconducting bulk material to exhibit good superconducting characteristics, the amount of oxygen in the 123 phase is important, and the oxygen content y in REBa₂Cu₃O_{y} satisfies 6.8 ≤ y ≤ 7.1. The material after the crystal growth has an oxygen deficiency amount of about 0.5, that is, y of about 6.5, and exhibits a semiconductor-like change in resistivity with temperature. By annealing such a material after crystal growth in an oxygen atmosphere at a temperature of 623 K to 873 K for about 100 hours depending on RE, oxygen is taken into the material after the crystal growth, and the oxygen deficiency amount becomes 0.2 or less, that is, y becomes 6.8 or more. As a result, the material after being annealed exhibits good superconducting characteristics and becomes an oxide superconducting bulk material. A twin structure may be generated in the 123 phase after being annealed. In the present specification, such a twin structure is also referred to as "single crystal". Hereinabove, the oxide superconducting bulk body 112 has been described.

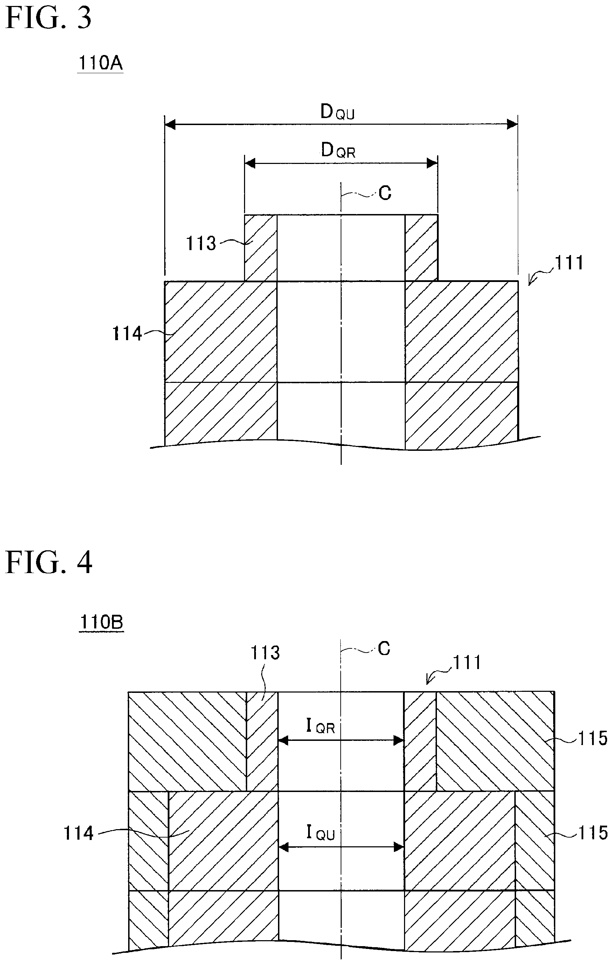

Subsequently, the structure of the magnet unit according to the present embodiment will be described with reference to FIGS. 2 to 6. FIG. 3 is a cross-sectional view of a magnet unit for nuclear magnetic resonance showing an example of a stacked state of the oxide superconducting bulk bodies according to the present embodiment. FIGS. 4 to 6 are cross-sectional views of magnet units for nuclear magnetic resonance showing other examples of the magnet unit for nuclear magnetic resonance according to the present embodiment.

As shown in FIG. 2, the magnet unit 110 of the present embodiment has the plurality of ring-shaped oxide superconducting bulk bodies 112, which are coaxially stacked in the coaxial direction to form the stacked body 111. That is, the plurality of oxide superconducting bulk bodies 112 are stacked in the central axis C direction so that the central axes C thereof are the same axis.

The oxide superconducting bulk body 112 has a ring shape (cylindrical shape) and is formed of the oxide superconducting bulk material described above. The oxide superconducting bulk body 112 may have, for example, a cylindrical shape or a polygonal ring shape such as a rectangular ring shape or a hexagonal ring shape. The oxide superconducting bulk body 112 preferably has a cylindrical shape. By causing the oxide superconducting bulk body 112 to have a cylindrical shape, a more uniform magnetic field can be formed in the bore space.

In the oxide superconducting bulk body 112, the so-called ab-plane of the oxide superconducting bulk material is stacked in the central axis C direction (height direction).

In addition, the "oxide superconducting bulk body" in the present specification refers to a superconducting bulk body partially or entirely containing the oxide superconducting bulk material having a fine structure of an oxide for exhibiting the characteristics of the above-mentioned superconductor. For example, the "superconducting bulk body" may also include a bulk body entirely formed of an oxide superconducting material (that is, a "bulk body"), and a stacked material formed of a combination of an oxide superconducting bulk material and a non-superconducting bulk material.

As shown in (b) and (c) of FIG. 2 of Non-Patent Document 1, regarding the superconducting current and the captured magnetic field distribution during or after magnetization, a large superconducting current flows particularly in the vicinity of the end surface of the ring at the end portion, and the captured magnetic field drops sharply near the end portion. On the other hand, a substantially uniform superconducting current is induced in the ring of the center portion from the outer circumferential portion, and a substantially uniform magnetic field is captured.

Such behavior differs depending on the magnetization conditions (temperature, and magnetic field strength), but is qualitatively similar. Therefore, the technical contents of the present invention will be described using such a model.

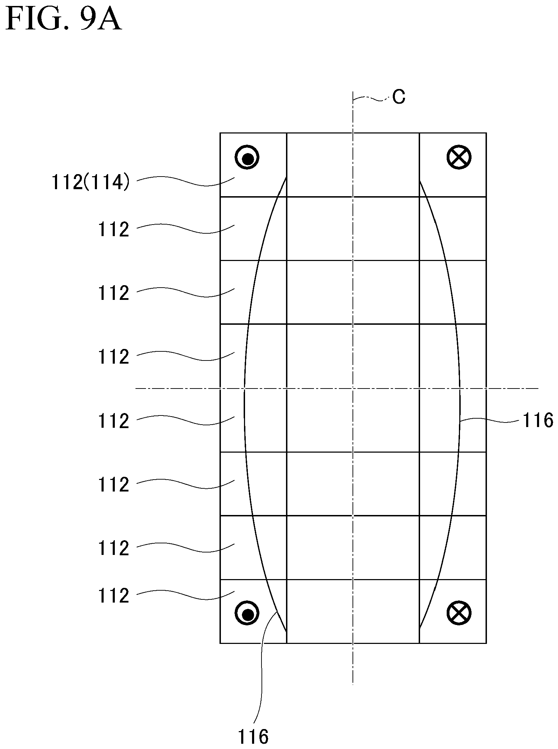

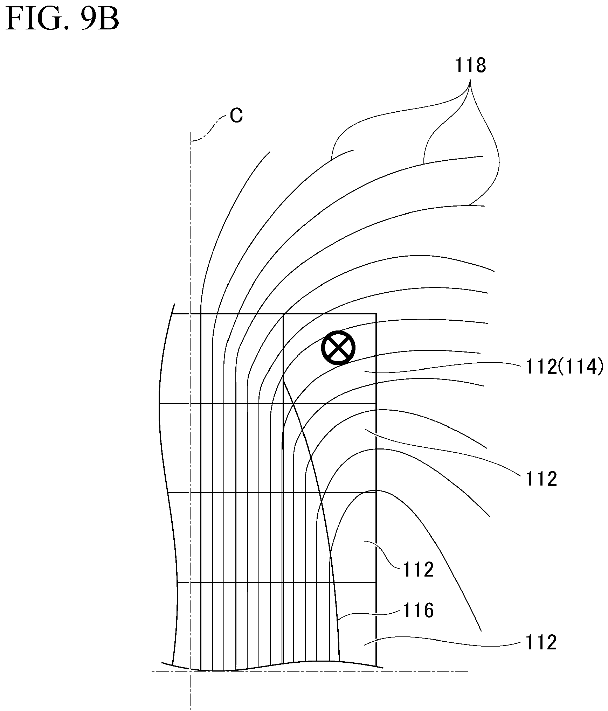

FIG. 9A shows a schematic diagram of the distribution of a superconducting current in a cross section in a magnet unit after being magnetization in a case where eight oxide superconducting bulk bodies 112 having the same outer diameter, thickness, and volume are stacked. In the magnetization process, a superconducting current is induced from the outer circumferential portion of the oxide superconducting bulk bodies 112. In particular, in the oxide superconducting bulk body 112 (114) at the end portion, a change in the magnetic flux density is large, so that a region where the superconducting current flows is expanded to the inside of the ring, compared to the oxide superconducting bulk body 112 at the center portion. An image of the boundary (line) between the region where the superconducting current flows and a region where no superconducting current flows is indicated by solid lines (116) in FIG. 9A. FIG. 9B shows a magnetic field distribution in a case where a superconducting current flows after magnetization as shown in FIG. 9A (only the upper right portion of FIG. 9A is shown due to symmetry). An image of lines of magnetic force is indicated by a plurality of solid lines (118) in FIG. 9B to show the form of the magnetic field distribution.

As shown in FIG. 9B, although a substantially uniform magnetic field is captured in the central axis C direction in the center portion FIG. 9A, at the end portion of the oxide superconducting bulk body 112, the magnetic field rapidly spreads in the radial direction of the oxide superconducting bulk body 112, and the magnetic field strength decreases. In such a situation, in the oxide superconducting bulk body 112 (114) at the end portion, the superconducting current flows in a wide region, and the superconducting current particularly in the inner circumferential portion of the end portion interlinks with lines of magnetic force having a high magnetic flux density. For this reason, a hoop stress that causes the oxide superconducting bulk body 112 to swell in the radial direction is generated in the oxide superconducting bulk body 112 (114) at the end portion, and tends to be increased particularly in the vicinity of the inner circumferential portion of the end portion. Due to the concentration of electromagnetic stress in the vicinity of the inner circumferential portion of the end portion, cracking from the vicinity of the inner circumferential portion of the end portion as the origin tends to occur. This causes a decrease in the magnetic field strength that can be generated in the entire stacked oxide superconducting bulk bodies 112.

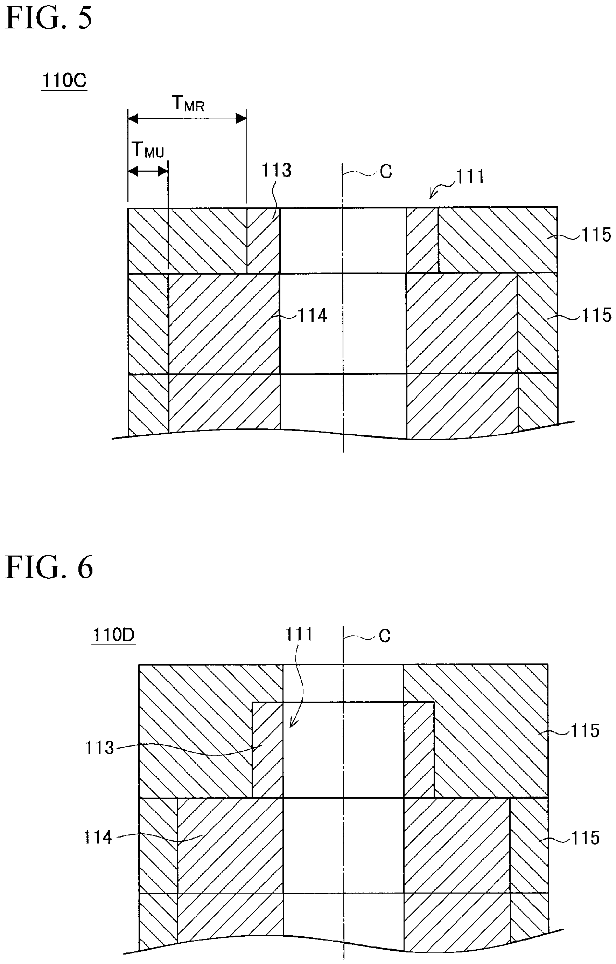

Although a specific stress distribution is not shown here, Non-Patent Document 1 shows a calculation example of the stress distribution in the case where ring-shaped oxide superconducting bulk bodies are stacked. In FIG. 1 of Non-Patent Document 1, the dimensions of the stacked bulk bodies are described. In addition, in (b) and (c) of FIG. 2 of Non-Patent Document 1, the magnetic field distribution and the distribution of the superconducting current flowing in the bulk bodies are shown, and the corresponding stress distribution is shown in the graph in (a) of FIG. 4 and (a) of FIG. 6 of Non-Patent Document 1. From the color-coded stress distribution diagram, it can be seen that the inner circumferential edge portion of the end surface of the oxide superconducting bulk body disposed at the end portion is red, which means that stress concentration occurs.

The stress generated during magnetization differs depending on the shape and arrangement of the oxide superconducting bulk bodies and magnetizing conditions such as temperature and application magnetic field, but in general, stress concentration similarly occurs at the inner circumferential edge portion of the end surface of the oxide superconducting bulk body disposed at the end portion.

Next, regarding a reduction in the maximum value of the stress at the inner circumferential edge portion of the end surface of the oxide superconducting bulk body 112 (114) disposed at the end portion by disposing the oxide superconducting bulk body 113 and relaxation of stress concentration, the principle will be qualitatively described.

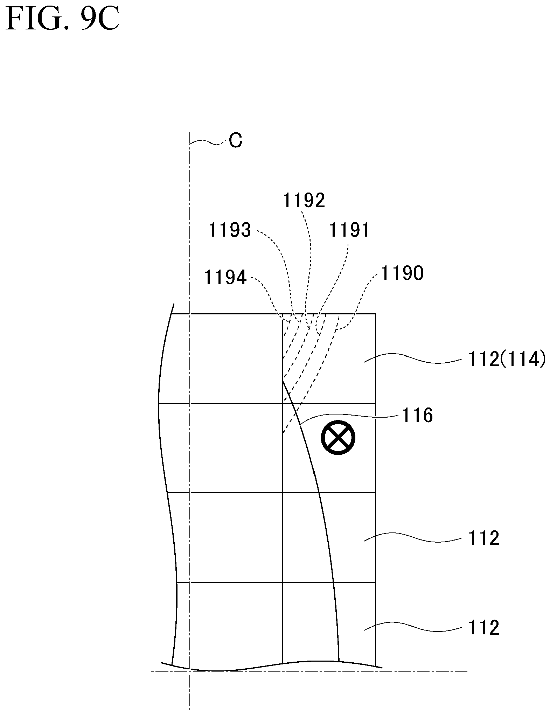

FIG. 9C shows a schematic diagram of the stress distribution in the situation corresponding to FIG. 9B. Contour lines of stress for showing the stress distribution are indicated by dotted lines 1190 to 1194. The magnitude of stress has a relationship of 1190 < 1191 < 1192 < 1193 < 1194. Similar to the stress distribution shown in the graph in (a) of FIG. 4 and (a) of FIG. 6 of Non-Patent Document 1, a distribution in which the hoop stress has a maximum value at the edge portion of the inner circumferential end portion of the oxide superconducting bulk body 114.

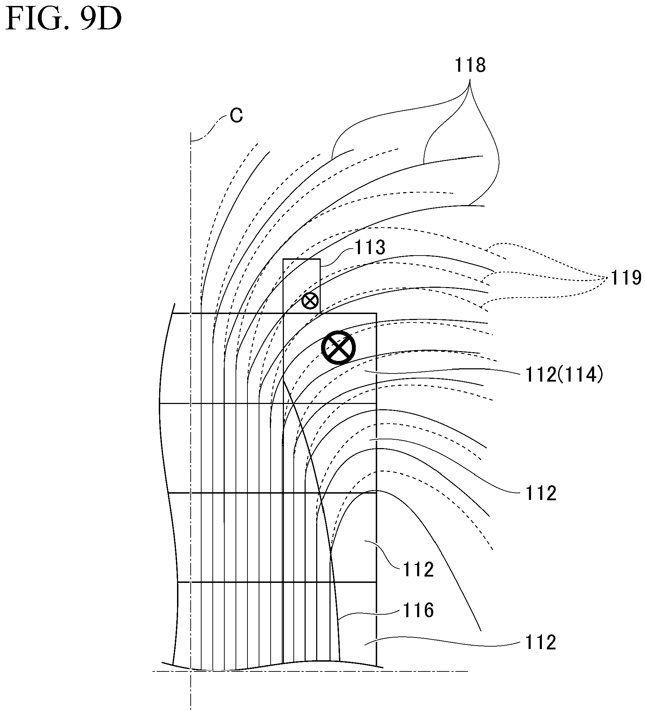

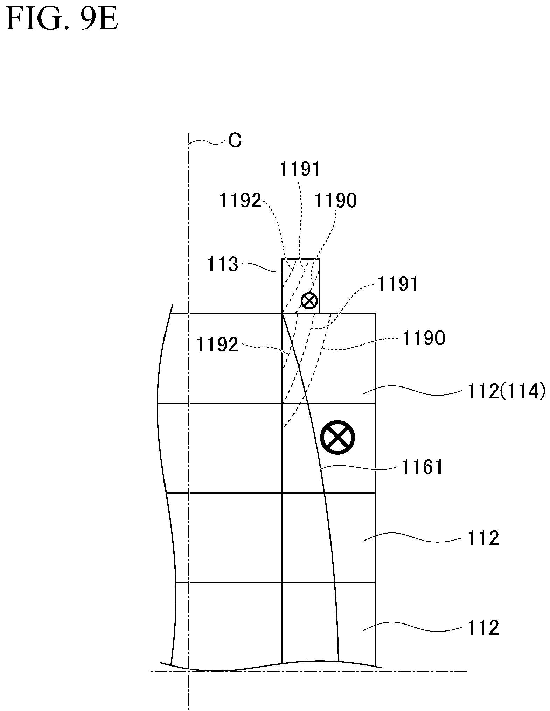

Next, FIG. 9E shows a schematic diagram of the stress distribution when the oxide superconducting bulk body 113 is disposed. In a case where the oxide superconducting bulk body 113 is disposed, a superconducting current is induced also in the oxide superconducting bulk body 113. The oxide superconducting bulk body 112 (114) is shielded by the superconducting current induced in the oxide superconducting bulk body 113, so that the induced current induced in the oxide superconducting bulk body 112 (114) is reduced. Therefore, the boundary between the region where the superconducting current flows and the region where no superconducting current flows changes from solid line 116 in FIG. 9C to solid line 1161 in FIG. 9E. In addition, at this time, an image of lines of magnetic force showing the form of the magnetic field is shown in FIG. 9D. Due to the change from solid line (118) in the case where the oxide superconducting bulk body 113 is absent to dotted line (119) in the case where the oxide superconducting bulk body 113 is disposed, a decrease in the magnetic field strength in the central axis C direction near the oxide superconducting bulk body 113 tends to be reduced. It should be noted that "a decrease in the magnetic field strength is reduced" means that a uniform and high-strength magnetic field is captured in the center portion of the oxide superconducting bulk body 112, but the magnetic field is reduced at the end portion. FIG. 9D shows a form in which the lines of magnetic force, which are at equal intervals in the center portion of the oxide superconducting bulk body 112, spread at the end portion, and the magnetic field strength is reduced. By disposing the oxide superconducting bulk body 113, the spread of the lines of magnetic force at the end portion becomes gentle. This means that the decrease in the magnetic field strength is reduced at the end portion (near the oxide superconducting bulk body 113). The decrease in the superconducting current mainly flowing in the oxide superconducting bulk body 112 (114) reduces the electromagnetic stress received by the oxide superconducting bulk body 112 (114) generated by the interaction between the current and the magnetic field. Based on such a principle, the stress distribution shown in FIG. 9C changes as shown in FIG. 9E, in the direction in which the stress concentration is relaxed. As a specific example, the stress distribution becomes contour lines indicated by dotted lines 1190 to 1192 in FIG. 9E. The magnitude of stress has a relationship of 1190 < 1191 < 1192 < 1193 < 1194, which indicates that the maximum value of stress is reduced and the stress concentration is relaxed. At this time, the same stress acts on the disposed oxide superconducting bulk body 113. It can be said that the stress acting on the oxide superconducting bulk body 112 (114) is reduced by the amount of the stress acting on the oxide superconducting bulk body 113, and the stress concentration is relaxed.

In the present embodiment, as shown in FIG. 2, in the magnet unit 110, the plurality of oxide superconducting bulk bodies 112 as described above are stacked in the height direction. As shown in FIG. 3, among the plurality of stacked oxide superconducting bulk bodies 112, the outer diameter D_{QR} of the oxide superconducting bulk body 113 (first oxide superconducting bulk body) disposed at one end or both ends of the stacked body 111 is smaller than the outer diameter D_{QU} of the oxide superconducting bulk body 114 (second oxide superconducting bulk body) adjacent to the oxide superconducting bulk body 113. In general, in a case where an oxide superconducting bulk unit formed by stacking oxide superconducting bulk bodies is magnetized with a strong magnetic field, electromagnetic stress is applied to the oxide superconducting bulk unit in a direction in which the oxide superconducting bulk radially expands, during the magnetization process. This electromagnetic stress becomes maximum at the edge portion of the inner circumferential surface of the end portion of the oxide superconducting bulk unit, particularly at the corner portion. In particular, in an oxide superconducting bulk unit in which the ratio of the stacking height to the outer diameter is large, electromagnetic stress concentrates on the edge portion of the inner circumferential surface of the oxide superconducting bulk unit. In a case where a crack occurs in the oxide superconducting bulk unit, cracking often occurs at this edge portion. However, by causing the outer diameter of the oxide superconducting bulk body 113 at the end portion to be smaller than the outer diameter of the adjacent oxide superconducting bulk body 114, it is possible to relax the concentration of electromagnetic stress generated at the edge portion of the inner circumferential surface of the oxide superconducting bulk body 113. As a result, it is possible to prevent cracking in the edge portion of the inner wall of the oxide superconducting bulk body 113, and to prevent cracking in a magnet unit 110A. Accordingly, the magnet unit 110A can capture a high-strength magnetic field. The outer diameter of the oxide superconducting bulk body 113 is preferably equal to or less than the average of the inner diameter and the outer diameter of the oxide superconducting bulk body 114.

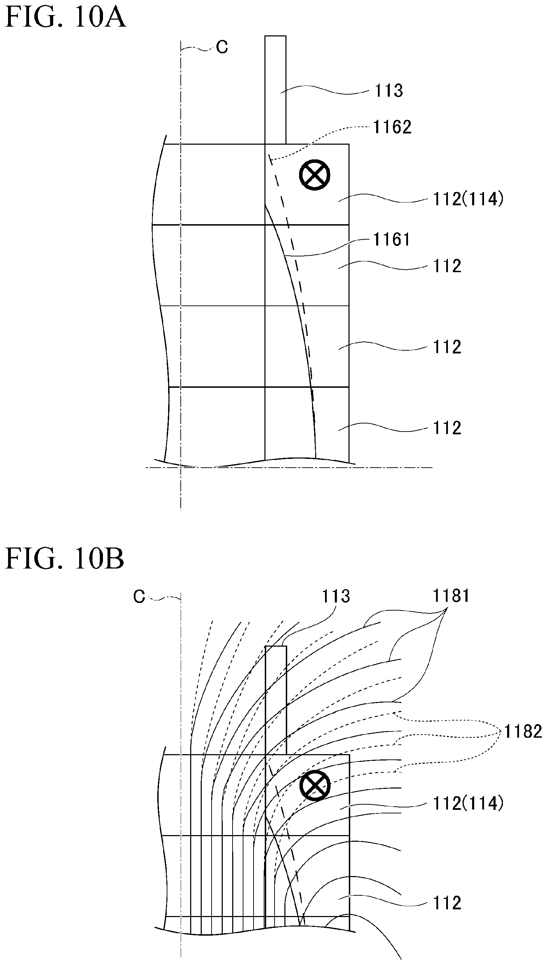

The fact that the magnet unit 110A can capture a high-strength magnetic field will be described in more detail with reference to FIGS. 10A and 10B.

FIG. 10A shows a schematic diagram of the distribution of a superconducting current in a cross section in a magnet unit after being magnetization in a case where ring bulk magnets (oxide superconducting bulk bodies) 113 having an outer diameter smaller than that of the oxide superconducting bulk bodies 112 are disposed at the upper and lower end portions of the eight stacked oxide superconducting bulk bodies 112 (114) shown in FIG. 9A. Since a superconducting current flows in the ring bulk magnets 113 by disposing the ring bulk magnets 113, the boundary (line) between the region where the superconducting current flows and the region where no superconducting current flows is changed from 1161 (solid line) to 1162 (dotted line). In FIG. 10B, an image of lines of magnetic force for showing the form of the magnetic field distribution in a case where the superconducting current flows as in FIG. 10A is indicated by 1182 (dotted lines). By disposing the ring bulk magnet 113 with respect to the image 1181 (solid lines) of the lines of magnetic force in the case where the ring bulk magnets 113 are not present, a superconducting current flows in the ring bulk magnets 113, so that a decrease in the magnetic field strength in the central axis C direction near the ring bulk magnets 113 tends to be reduced. This is because the superconducting current flowing in the oxide superconducting bulk bodies 112 (114) disposed at the end portions is reduced by the amount of the superconducting current flowing in the ring bulk magnets 113. Due to this effect, the current interlinking with the magnetic flux in the oxide superconducting bulk bodies 112 (114) disposed at the end portions is reduced, and the hoop stress is reduced. The reduced stress substantially corresponds to the hoop stress acting on the ring bulk magnets 113. In this manner, the electromagnetic stress is distributed in the vicinity of the inner circumference of the oxide superconducting bulk body 112 (114) where the electromagnetic stress is concentrated, and it is possible to capture a higher magnetic field in the stacked magnets as a whole.

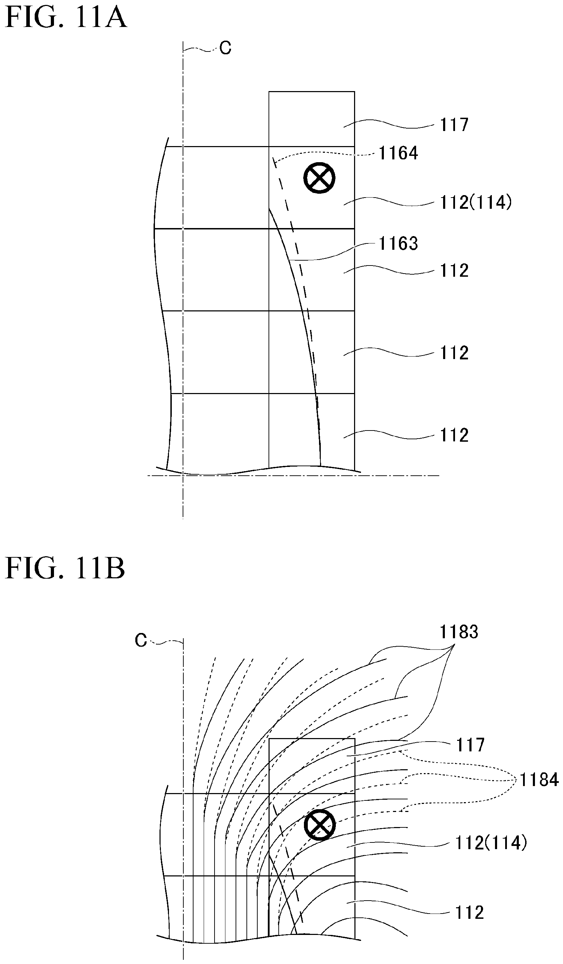

The same applies to a case where a ring bulk magnet (oxide superconducting bulk body) 117 having a small volume is disposed. FIG. 11A shows a schematic diagram of the distribution of a superconducting current in a cross section in a magnet unit after being magnetization in a case where ring bulk magnets 117 having a volume smaller than that of the oxide superconducting bulk bodies 112 are disposed at the upper and lower end portions of the eight stacked oxide superconducting bulk bodies 112 shown in FIG. 9A. Since a superconducting current flows in the ring bulk magnets 117 by disposing the ring bulk magnets 117, the boundary (line) between the region where the superconducting current flows and the region where no superconducting current flows is changed from 1163 (solid line) to 1164 (dotted line). In FIG. 11B, an image of lines of magnetic force for showing the form of the magnetic field distribution in a case where the superconducting current flows as in FIG. 11A is indicated by 1184 (dotted lines). By disposing the ring bulk magnet 117 with respect to the image 1183 (solid lines) of the lines of magnetic force in the case where the ring bulk magnets 117 are not present, a superconducting current flows in the ring bulk magnets 117, so that a decrease in the magnetic field strength in the central axis C direction near the ring bulk magnets 117 tends to be reduced. This is also because the superconducting current flowing in the oxide superconducting bulk bodies 112 (114) disposed at the end portions is reduced by the amount of the superconducting current flowing in the ring bulk magnets 117. Due to this effect, the current interlinking with the magnetic flux in the oxide superconducting bulk bodies 112 (114) disposed at the end portions is reduced, and the hoop stress is reduced. The reduced stress substantially corresponds to the hoop stress acting on the ring bulk magnets 117. In this manner, the electromagnetic stress is distributed and relaxed in the vicinity of the inner circumference of the oxide superconducting bulk body 112 (114) where the electromagnetic stress is concentrated, and it is possible to capture a higher magnetic field in the stacked magnets as a whole.

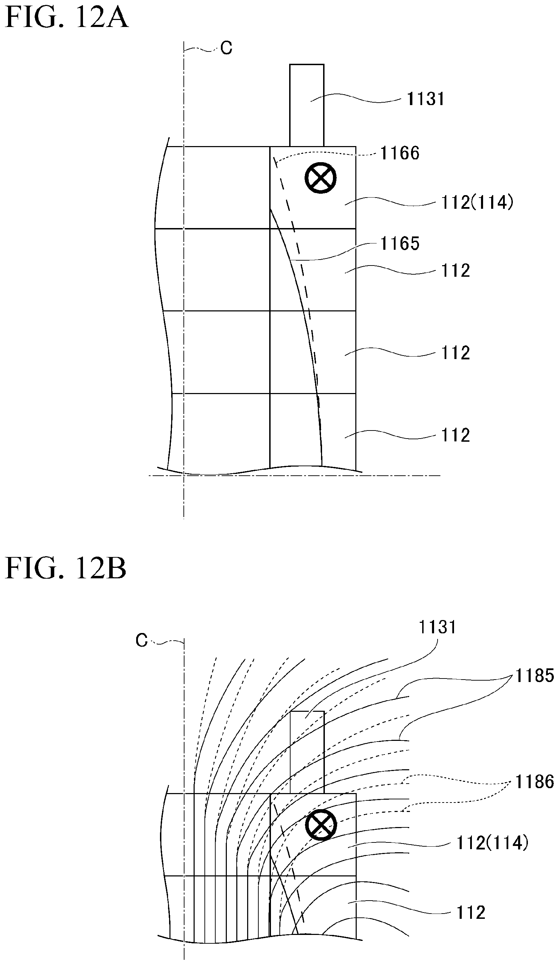

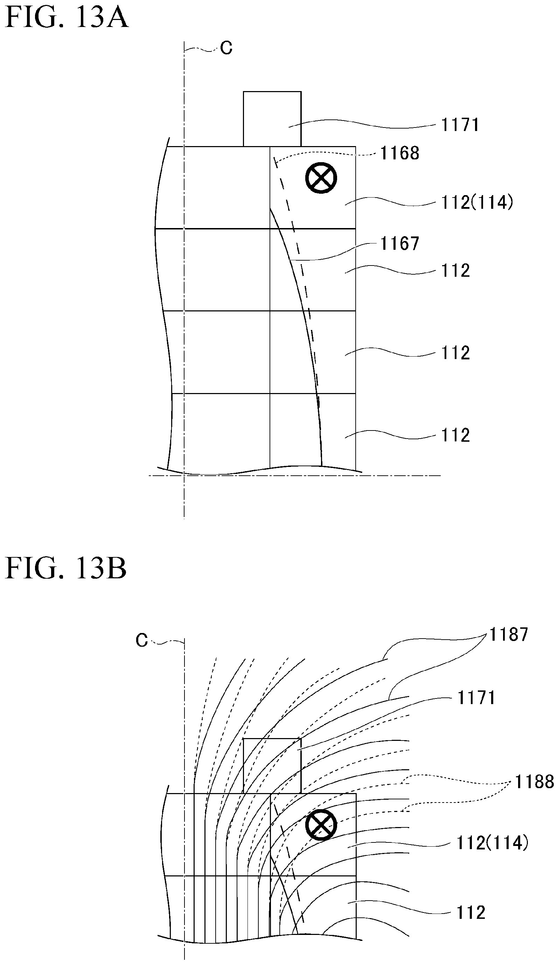

The same applies to a case where ring bulk magnets (oxide superconducting bulk bodies) having a small radial thickness are disposed at the upper and lower end portions of the oxide superconducting bulk bodies 112. That is, as shown in FIGS. 12A to 13B, in a case where ring bulk magnets (oxide superconducting bulk bodies) 1131 and 1171 having a small radial thickness are disposed at the upper and lower end portions of the oxide superconducting bulk bodies 112, it is possible to obtain the same effect as in the case where the ring bulk magnets 113 having an outer diameter smaller than that of the oxide superconducting bulk bodies 112 are disposed and the case where the ring bulk magnets 117 having a volume smaller than that of the oxide superconducting bulk bodies 112 are disposed.

Furthermore, in a case where the radial thickness is made small and the height is made high, the outer circumference reinforcement can be strengthened, which is desirable. Moreover, by making the outer diameter small, cost advantages such as manufacturing costs can be obtained, and strengthening of the outer circumference reinforcement can be achieved, which is more desirable. It is more desirable that the volume is small.

As described above, by causing the outer diameter, radial thickness, or volume of the oxide superconducting bulk bodies (first oxide superconducting bulk bodies) 113 and 117 disposed at one end or both ends of the stacked body among the plurality of oxide superconducting bulk bodies to be smaller than the outer diameter, radial thickness, or volume of the oxide superconducting bulk bodies (second oxide superconducting bulk bodies) 114 adjacent to the oxide superconducting bulk bodies (first oxide superconducting bulk bodies) 113 and 117, a higher magnetic field can be generated. However, the effect is greatest in a case where the outer diameter, radial thickness, and volume of the oxide superconducting bulk bodies(first oxide superconducting bulk bodies) 113 and 117 are smaller than the outer diameter, radial thickness, and volume of the oxide superconducting bulk bodies (second oxide superconducting bulk bodies) 114 adjacent to the oxide superconducting bulk bodies (first oxide superconducting bulk bodies) 113 and 117.

Furthermore, in the above description, although the oxide superconducting bulk body 113 (first oxide superconducting bulk body) disposed at one end or both ends of the stacked body 111 is described as one layer, it is possible to form the oxide superconducting bulk body 113 into two layers to distribute and relax the concentration of electromagnetic stress in two steps. In this case, regarding the outer diameters of the two layers of the oxide superconducting bulk body corresponding to the oxide superconducting bulk body 113, the outer diameter of the oxide superconducting bulk body 113 in the layer located at the end portion is smaller. Similarly, it is possible to form the oxide superconducting bulk body 117 into two layers to distribute and relax the concentration of electromagnetic stress in two steps. In this case, regarding the volumes of the two layers of the oxide superconducting bulk body corresponding to the oxide superconducting bulk body 117, the volume of the oxide superconducting bulk body 117 in the layer located at the end portion is smaller. Similarly, it is also possible to form the oxide superconducting bulk body having a small thickness into two layers to distribute and relax the concentration of electromagnetic stress in two steps. In this case, regarding the thicknesses of the two layers of the oxide superconducting bulk body corresponding to the oxide superconducting bulk body, the thickness of the oxide superconducting bulk body in the layer located at the end portion is smaller.

As shown in FIG. 4, the inner diameter I_{QR} of the oxide superconducting bulk body 113 is preferably set to 80% or more and 140% or less of the inner diameter I_{QU} of the oxide superconducting bulk body 114. By setting the inner diameter I_{QR} of the oxide superconducting bulk body 113 to 80% or more of the inner diameter I_{QU} of the oxide superconducting bulk body 114, it is possible to cause the bore space to have a size large enough to insert the analysis sample. Furthermore, by setting the inner diameter I_{QR} of the oxide superconducting bulk body 113 to be 140% or less of the inner diameter I_{QU} of the oxide superconducting bulk body 114, the inner circumferential portion of the oxide superconducting bulk body 113 does not become too far from the inner circumferential edge of the oxide superconducting bulk body 114, which is a stress concentration portion, and thus a stress relaxation effect can be secured. Therefore, it is possible to further relax the concentration of electromagnetic stress on the edge portion of the inner circumferential portion of the oxide superconducting bulk body 114. As described above, by setting the inner diameter I_{QR} of the oxide superconducting bulk body 113 to be in the above range, it is possible to relax the electromagnetic stress occurring on the inner circumferential surface of the oxide superconducting bulk body 113 and the electromagnetic stress occurring on the inner circumferential surface of the oxide superconducting bulk body 114. As a result, it is possible to prevent the occurrence of cracking on the inner circumferential surface of the oxide superconducting bulk body 113 and the occurrence of cracking on the inner circumferential surface of the oxide superconducting bulk body 114. More preferably, the oxide superconducting bulk body 113 has the same inner diameter as that of the oxide superconducting bulk body 114. In addition, it is preferable that the inner diameter of the oxide superconducting bulk body 113 substantially coincide with the inner diameter of the oxide superconducting bulk body 114 from the viewpoint of inserting the analysis sample.

The length (height) of the oxide superconducting bulk body 113 in the central axis C direction can be set to, for example, 1% or more and 50% or less of the height of the stacked body 111. From the viewpoint of relaxation of electromagnetic stress and the viewpoint of manufacturing costs, the height of the oxide superconducting bulk body 113 is preferably 2% or more and 30% or less, and more preferably 3% or more and 20% or less of the height of the stacked body 111.

In the space inside the magnet unit according to the present embodiment, as described above, the recessed part 131 of the heat insulating container 130 is disposed, and the analysis sample is inserted into the recessed part 131. It is important to insert the analysis sample into a uniform magnetic field space. By setting the inner diameter of the center portion of the magnet unit according to the present embodiment in the axial direction to be larger than the inner diameter of the end portion, a magnetic field that cancels out a non-uniform magnetic field generated by the magnetization of the oxide superconducting bulk body 112 is formed in the bore space of the magnet unit according to the present embodiment. Therefore, for example, the space inside the magnet unit according to the present embodiment is preferably large.

The plurality of stacked oxide superconducting bulk bodies 112 can be bonded to the adjacent oxide superconducting bulk bodies 112 with, for example, a solder, a resin, or grease.

In the present embodiment, a magnet unit 110C has the support member 115 on the outer circumferential surface side of the oxide superconducting bulk body 113 and the oxide superconducting bulk bodies 114, as shown in FIG. 5, for example.

The support members 115 are provided at least on the outer circumferential surface side of the oxide superconducting bulk body 113 and the oxide superconducting bulk bodies 114. The support members 115 physically reinforce the adjacent oxide superconducting bulk body 113 and the oxide superconducting bulk bodies 114. As the material of the support member 115, for example, a material that has high strength, non-magnetic properties, and a thermal contraction rate larger than that of the oxide superconducting bulk body 112 can be used. In addition, as the material of the support member 115, a material having a high thermal conductivity can be preferably used. For the support member 115, for example, copper, a copper alloy, aluminum, an aluminum alloy, austenitic stainless steel, carbon fiber reinforced plastic, or the like is preferably used.

The shape of the support member 115 is not particularly limited as long as the shape can reinforce at least the oxide superconducting bulk body 113 and the oxide superconducting bulk bodies 114. For example, the shape of the support member 115 may be a ring shape (cylindrical shape) having a hollow portion in a shape corresponding to the shape of the oxide superconducting bulk body 113 and the oxide superconducting bulk bodies 114.

Furthermore, the support members 115 are disposed in contact with the outer circumferential surface of the magnet unit according to the present embodiment. The support members 115 disposed in contact with the outer circumferential surface of the magnet unit according to the present embodiment have one end thermally connected to the cold head 121, as shown in FIG. 1, for example. Accordingly, the support members 115 can more efficiently cool the magnet unit according to the present embodiment from the outside.

As shown in FIG. 2, in a case where the support member 115 has a ring shape, the oxide superconducting bulk bodies 112 are respectively fitted in a plurality of the support members 115. However, the present invention is not limited to the shown embodiment, and for example, the support members may be integrally formed.

The support member 115 and the oxide superconducting bulk body 112 can be bonded with, for example, a solder, a resin, or grease. In a case where the plurality of support members 115 are used, the support members 115 can be bonded with, for example, a solder, a resin, or grease.

As shown in FIG. 5, the thickness T_{MR} of a part of the support member 115 located on the outer circumferential surface of the oxide superconducting bulk body 113 is preferably larger than the thickness T_{MU} of a part of the support member 115 located on the outer circumferential surface of the oxide superconducting bulk body 114. Since the outer diameter D_{QR} of the oxide superconducting bulk body 113 is smaller than the outer diameter D_{QU} of the oxide superconducting bulk body 114, a thick support member 115 can be disposed on the outer circumferential surface of the oxide superconducting bulk body 113 without increasing the outer diameter of the magnet unit. Since the oxide superconducting bulk body 113 having a small outer diameter has a small cross-sectional area perpendicular to the central axis C direction, a relatively small superconducting current flows in the oxide superconducting bulk body 113. As a result, electromagnetic stress acting on the oxide superconducting bulk body 113 is limited. Since the oxide superconducting bulk body 113 on which this relatively small electromagnetic stress acts is supported by the support member 115 having a large thickness, the magnet unit 110C can maintain a strong magnetic field without causing cracking of the oxide superconducting bulk body 113. Furthermore, in the magnet unit 110C, since the volume of the stacked body 111 is larger than that of a magnet unit that does not have the oxide superconducting bulk body 113, a larger superconducting current can be flowed. As a result, the magnet unit 110C can generate a uniform magnetic field in the bore space. More preferably, the thickness T_{MR} is larger than the thickness T_{MU}, and the outer diameter of the part of the support member 115 located on the outer circumferential surface of the oxide superconducting bulk body 113 is equal to or less than the outer diameter of the part of the support member 115 located on the outer circumferential surface of the oxide superconducting bulk body 114. For example, the outer diameter of the part of the support member 115 located on the outer circumferential surface of the oxide superconducting bulk body 114 is 120% or less of the outer diameter of the part of the support member 115 located on the outer circumferential surface of the oxide superconducting bulk body 113.

It is desirable that the outer diameter of the support member 115 located on the outer circumferential surface side of the oxide superconducting bulk body 113 is large. However, when the outer diameter of the part of the support member 115 located on the outer circumferential surface side of the oxide superconducting bulk body 113 is large, the inner diameter of the room temperature bore of the superconducting magnet for magnetization also needs to be large in accordance with the support member 115. Therefore, the outer diameter of the part of the support member 115 located on the outer circumferential surface side of the oxide superconducting bulk body 113 is preferably the same as the outer diameter of the part of the support member 115 located on the outer circumferential surface side of the oxide superconducting bulk body 112 other than the oxide superconducting bulk body 113.

Furthermore, in the present embodiment, as shown in FIG. 6, the support member 115 extends so as to cover at least a part of the outer surface side end surface (upper surface) of the oxide superconducting bulk body 113. The end surface mentioned here is a surface located in the central axis C direction in the cylindrical oxide superconducting bulk body 113.

In the magnetizing process of a magnet unit 110D, stress concentrates on the edge portion of the inner circumferential surface of the oxide superconducting bulk body 113. However, by bringing the support member 115 into close contact with the upper surface of the oxide superconducting bulk body 113, strain can be suppressed, and it is possible to prevent cracking in the edge portion of the inner circumferential surface of the oxide superconducting bulk body 113.

In an oxide superconducting bulk unit in the related art, for example, the oxide superconducting bulk unit in which the metal ring is fixed to the outer circumferential surface and the end surface perpendicular to the central axis described in Non-Patent Document 1, the outer diameter of the oxide superconducting bulk body disposed at the end portion is the same as the outer diameter of the oxide superconducting bulk body adjacent to the oxide superconducting bulk body. In the oxide superconducting bulk unit in the related art, due to the difference between the thermal contraction rate of the oxide superconducting bulk body and the thermal contraction rate of the metal ring, at the contact surface between the oxide superconducting bulk body and the metal ring, a force that makes the oxide superconducting bulk body and the metal ring deviate from each other (peel away from each other) increases in the direction from the contact surface between an outer circumferential reinforcing ring disposed on the outer circumferential surface and the oxide superconducting bulk body toward the central axis. In addition, in general, the plane perpendicular to the central axis of the oxide superconducting bulk body is a plane called an ab-plane, which is easily cleaved. Therefore, in the oxide superconducting bulk unit in the related art, since the outer diameter of the oxide superconducting bulk body at the end portion is large, there is a possibility that peeling may occur in the vicinity of the bonded surface between the oxide superconducting bulk body and the metal ring when the above tension acts. However, the oxide superconducting bulk body 113 has a smaller outer diameter than the oxide superconducting bulk body 114. Since the oxide superconducting bulk body 113 has a small outer diameter, the distance from the contact surface between the oxide superconducting bulk body 113 and the support member 115 disposed on the outer circumferential surface thereof to the central axis becomes short. Accordingly, the force of peeling caused by the difference between the thermal contraction rate of the oxide superconducting bulk body 113 and the thermal contraction rate of the support member 115 becomes smaller than the force that acts between the oxide superconducting bulk body and the metal ring in the oxide superconducting bulk unit in the related art. Therefore, peeling in the vicinity of the contact surface between the oxide superconducting bulk body 113 and the support member 115 disposed on the upper surface thereof is suppressed. As a result, the support member 115 is brought into close contact with the upper surface of the oxide superconducting bulk body 113, and strain can be suppressed, so that it is possible to prevent cracking in the edge portion of the inner circumferential surface of the oxide superconducting bulk body 113.

The support member 115 disposed on the upper surface of the oxide superconducting bulk body 113 may be integrated with a portion disposed on the outer circumference of the oxide superconducting bulk body 113, or the support member 115 disposed on the upper surface of the oxide superconducting bulk body 113 and the support member 115 disposed on the outer circumference of the oxide superconducting bulk body 113, which is separately manufactured, and may be fixed to each other and integrated.

According to the present invention, it is possible to provide the magnet unit for nuclear magnetic resonance and the magnetic field generating device for nuclear magnetic resonance capable of preventing damage to the superconducting bulk body and generating a magnetic field of higher strength.

The magnet unit according to the present embodiment is applicable to an NMR apparatus in which a refrigerating device provided with a cold head is used, and an NMR apparatus which applies a method of cooling an oxide superconducting bulk material using a cooling medium. The magnet unit according to the present embodiment is also applicable to an NMR apparatus having a pressure reducing device for further lowering the temperature of the cooling medium.

### <3. Modification Example>

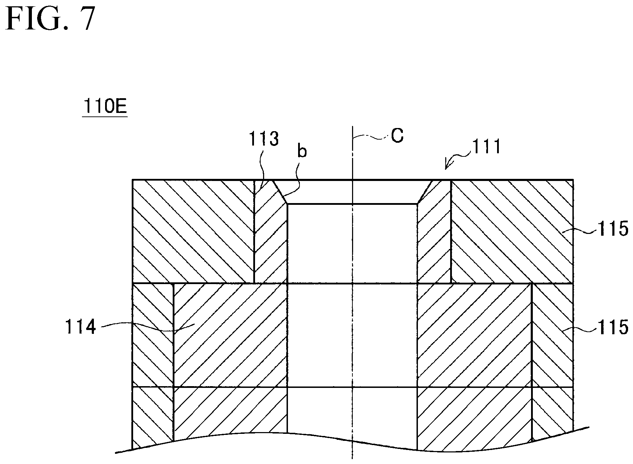

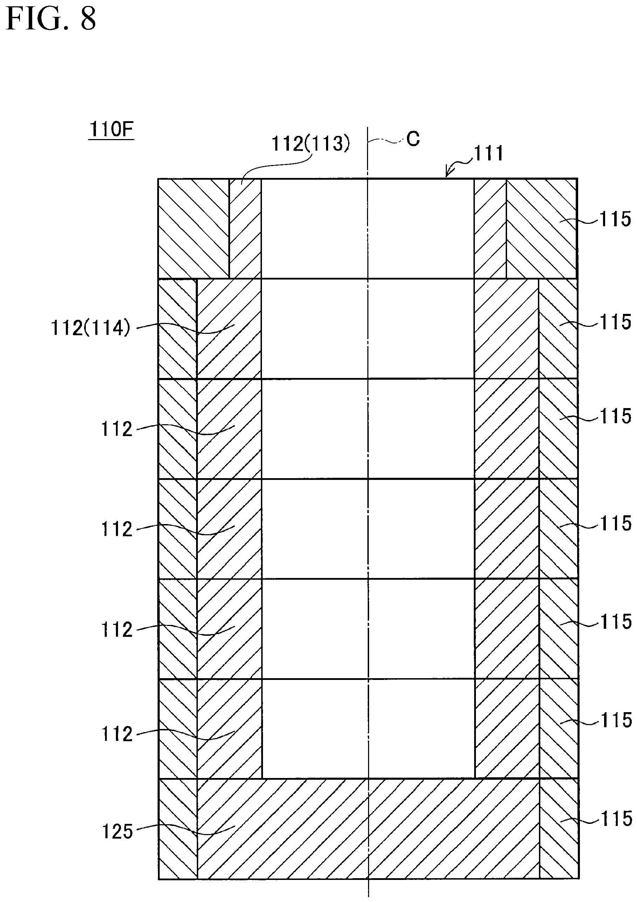

Hereinabove, the embodiment of the present invention has been described. Hereinafter, modification examples of the above-described embodiment of the present invention will be described with reference to FIGS. 7 and 8. FIG. 7 is a cross-sectional view of a magnet unit for nuclear magnetic resonance showing a modification example of the magnet unit for nuclear magnetic resonance according to the present embodiment. FIG. 8 is a cross-sectional view showing an example of the magnet unit for nuclear magnetic resonance according to the present embodiment placed on the cold head. The modification example described below can be additionally applied to the configuration described in the above embodiment of the present invention.

The inner circumferential portion of the outer surface side end surface of a magnet unit 110E can be chamfered as shown in FIG. 7. The end surface mentioned here is a surface located in the central axis C direction in the cylindrical oxide superconducting bulk body 113. By chamfering the inner circumferential portion of the outer surface side end surface of the magnet unit 110E, it is possible to relax the concentration of magnetic field stress. At the inner circumferential edge portion of the end portion (outer side) of the cylindrical oxide superconducting bulk body 113, stress concentration similarly occurs from the viewpoint of the entire oxide superconducting bulk body 113. Therefore, in order to relax such stress concentration, the inner circumferential edge portion may be removed. By chamfering the inner circumferential edge portion as shown in FIG. 7, the stress concentration is distributed around the chamfered surface and relaxed.

The shape of a chamfered portion b, which is the chamfered portion, is not particularly limited as long as the shape can relax the concentration of the magnetic field stress while maintaining the uniformity of the magnetic field, and may have an angular surface or round surface. The support member 115 may be disposed in contact with the chamfered portion b.

While the case where the oxide superconducting bulk body 113 is mainly disposed at one end of the magnet unit according to the present embodiment has been described above regarding the structure of the magnet unit according to the present embodiment, the oxide superconducting bulk body 113 may be provided at both ends of the magnet unit according to the present embodiment. At this time, the oxide superconducting bulk body 113 disposed at one end of the magnet unit according to the present embodiment and the oxide superconducting bulk body 113 disposed at the other end of the magnet unit according to the present embodiment may have the same structure, or have different structures among the above-described structures.

As shown in FIG. 8, a magnet unit 110F further includes a plate-shaped oxide superconducting bulk body 125. The oxide superconducting bulk body 113 is disposed at one end of the magnet unit 110F, and the plate-shaped oxide superconducting bulk body 125 can be disposed at the other end opposite to the one end where the oxide superconducting bulk body 113 is disposed. Unlike the ring-shaped bulk body, the plate-shaped oxide superconducting bulk body 125 has no inner circumferential edge portion where stress concentration occurs. Therefore, the electromagnetic stress generated at the other end of the magnet unit 110F is relatively distributed and relaxed in the bulk body. Furthermore, by placing the magnet unit 110F on the cold head 121 so that the oxide superconducting bulk body 125 is connected to the cold head 121 (see FIG. 1), the contact area with the cold head 121 increases, and it is possible to improve the cooling efficiency of the magnet unit 110F.

### [Examples]

Hereinafter, the embodiment of the present invention will be specifically described with reference to examples. The following examples are merely examples of the present invention, and the present invention is not limited to the following examples.

### (Example 1)

A ring-shaped oxide superconducting bulk body having an outer diameter of 40 mm, an inner diameter of 24 mm, and a height of 15 mm was produced by using Gd as RE. An aluminum alloy ring having a thickness of 17 mm and a height of 15 mm was used as a support member. A resin (STYCAST manufactured by Henkel Ablestik Japan Ltd.) was applied to the inner circumferential surface of the aluminum alloy ring, the produced oxide superconducting bulk body was fitted into the aluminum alloy ring, and then the resin was allowed to solidify, thereby producing a first fitted body. Two first fitted bodies were manufactured.

In addition, a ring-shaped oxide superconducting bulk body having an outer diameter of 60 mm, an inner diameter of 24 mm, and a height of 20 mm was prepared by using Gd as RE. An aluminum alloy ring having a thickness of 7 mm and a height of 20 mm was used as the support member. The same resin as above was applied to the inner circumferential surface of this aluminum alloy ring, and the produced oxide superconducting bulk body was fitted into the aluminum alloy ring, thereby producing a second fitted body. Six second fitted bodies were manufactured.

The six second fitted bodies were stacked, the first fitted bodies were respectively disposed on the two end surfaces thereof, and the first fitted bodies and the second fitted bodies, and the second fitted bodies were bonded with vacuum grease, thereby manufacturing a magnet unit. At this time, the respective fitted bodies were bonded so that the central axes of the fitted bodies constituting the magnet unit were aligned. The aluminum alloy ring of the magnet unit was provided with a screw hole for fixing to a cold head.

The oxide superconducting bulk body was formed of a 123 phase and a 211 phase in a molar ratio of 3:1 and the average particle size of the 211 phase was 1 µm.

Vacuum grease was applied to one end of the magnet unit and the magnet unit was placed on the cold head, and a screw was passed through the screw hole to fix the magnet unit to the cold head. The magnet unit was cooled to 100 K using a cooling device, and thereafter placed in a hollow space of a magnetic field generating coil, and a magnetic field of 8.5 T was applied thereto. Subsequently, the magnet unit was cooled to 40 K, the application magnetic field of the magnetic field generating coil was demagnetized, and the magnet unit was magnetized with the magnetic field, thereby obtaining an oxide superconducting bulk magnet.

In the obtained oxide superconducting bulk magnet, a captured magnetic field of 8.5 T was confirmed in the central part. The oxide superconducting bulk magnet was heated so as to be demagnetized, and thereafter cooled to room temperature to observe the external appearance of the magnet unit. Damage such as cracking had not occurred therein.

As a comparative example, six second fitted bodies were produced in the same manner as above. The six second fitted bodies thus produced were stacked, and the second fitted bodies were bonded together with vacuum grease, thereby manufacturing a magnet unit. At this time, the respective fitted bodies were bonded so that the central axes of the fitted bodies constituting the magnet unit were aligned. The aluminum alloy ring of the magnet unit was provided with a screw hole for fixing to a cold head.

The magnet unit constituted by the six second fitted bodies was fixed to the cold head in the same manner as above, and magnetized under the same conditions as above, thereby obtaining an oxide superconducting bulk magnet.

In this oxide superconducting bulk magnet, a captured magnetic field of 8.2 T was confirmed in the central part. The oxide superconducting bulk magnet was heated so as to be demagnetized, and thereafter cooled to room temperature to observe the external appearance of the magnet unit. Cracking had occurred therein.

### (Example 2)

A ring-shaped oxide superconducting bulk body having an outer diameter of 46 mm, an inner diameter of 24 mm, and a height of 10 mm was produced by using Eu as RE. A copper alloy ring having a thickness of 14 mm and a height of 10 mm was used as a support member. Solder was applied to the inner circumferential surface of this copper alloy ring, the produced oxide superconducting bulk body was fitted into the aluminum alloy ring, and then the solder was allowed to solidify, thereby producing a first fitted body. Two first fitted bodies were manufactured.

In addition, a ring-shaped oxide superconducting bulk body having an outer diameter of 60 mm, an inner diameter of 24 mm, and a height of 20 mm was prepared by using Eu as RE. An aluminum alloy ring having a thickness of 7 mm and a height of 20 mm was used as the support member. The same resin as in Example 1 was applied to the inner circumferential surface of this aluminum alloy ring, and the produced oxide superconducting bulk body was fitted into the aluminum alloy ring, thereby producing a second fitted body. Two second fitted bodies were manufactured.

Furthermore, a ring-shaped oxide superconducting bulk body having an outer diameter of 60 mm, an inner diameter of 35 mm, and a height of 20 mm was produced using Eu as RE. An aluminum alloy ring having a thickness of 7 mm and a height of 20 mm was used as the support member. The same resin as in Example 1 was applied to the inner circumferential surface of this aluminum alloy ring, and the produced oxide superconducting bulk body was fitted into the aluminum alloy ring, thereby producing a third fitted body. Four third fitted bodies were manufactured.

The four third fitted bodies were stacked, the second fitted bodies were respectively disposed on the two end surfaces thereof, and furthermore, the first fitted bodies were respectively disposed on both ends thereof, and the first fitted bodies and the second fitted bodies, the second fitted bodies and the third fitted bodies, and the third fitted bodies were bonded with vacuum grease, thereby manufacturing a magnet unit. At this time, the respective fitted bodies were bonded so that the central axes of the fitted bodies constituting the magnet unit were aligned. The copper alloy ring of the magnet unit was provided with a screw hole for fixing to a cold head.

The oxide superconducting bulk body was formed of a 123 phase and a 211 phase in a molar ratio of 3:1 and the average particle size of the 211 phase was 1 µm.

Vacuum grease was applied to one end of the magnet unit and the magnet unit was placed on the cold head, and a screw was passed through the screw hole to fix the magnet unit to the cold head. The magnet unit was cooled to 100 K using a cooling device, and thereafter placed in a hollow space of a magnetic field generating coil, and a magnetic field of 9.0 T was applied thereto. Subsequently, the magnet unit was cooled to 35 K, the application magnetic field of the magnetic field generating coil was demagnetized, and the magnet unit was magnetized with the magnetic field, thereby obtaining an oxide superconducting bulk magnet.

In the obtained oxide superconducting bulk magnet, a captured magnetic field of 9.0 T was confirmed in the central part. The oxide superconducting bulk magnet was heated so as to be demagnetized, and thereafter cooled to room temperature to observe the external appearance of the magnet unit. Damage such as cracking had not occurred therein.

As a comparative example, two second fitted bodies and four third fitted bodies were produced in the same manner as above. The four third fitted bodies were stacked, the second fitted bodies were respectively disposed on the two end surfaces thereof, and the second fitted bodies and the third fitted bodies, and the third fitted bodies were bonded with vacuum grease, thereby manufacturing a magnet unit. At this time, the respective fitted bodies were bonded so that the central axes of the fitted bodies constituting the magnet unit were aligned. The aluminum alloy ring of the magnet unit was provided with a screw hole for fixing to a cold head.

The magnet unit constituted by the two second fitted bodies and the four third fitted bodies was fixed to the cold head in the same manner as above, and magnetized under the same conditions as above, thereby obtaining an oxide superconducting bulk magnet.

In this oxide superconducting bulk magnet, a captured magnetic field of 7.0 T was confirmed in the central part. The oxide superconducting bulk magnet was heated so as to be demagnetized, and thereafter cooled to room temperature to observe the external appearance of the magnet unit. Cracking had occurred in the second fitted body.

As described above, according to the present invention, the magnet unit is prevented from being damaged and can generate a magnetic field of higher strength.

While the preferred embodiments of the present invention have been described above in detail with reference to the accompanying drawings, the present invention is not limited to such examples. It is obvious that a person having ordinary knowledge in the technical field to which the present invention pertains can come up with various changes or modifications within the scope of the invention as defined by the claims.

### [Industrial Applicability]

According to the present invention, it is possible to provide a magnet unit for nuclear magnetic resonance and a magnetic field generating device for nuclear magnetic resonance capable of preventing damage to a superconducting bulk body and generating a magnetic field of higher strength. Therefore, the present invention has extremely great industrial applicability.

### [Brief Description of the Reference Symbols]

1 NMR apparatus
10 Magnetic field generating device
20 Control device
30 High frequency generating device
40 Detecting coil
110, 110A, 110B, 110C, 110D, 110E, 110F Magnet unit
111 Stacked body
112, 113, 114, 117, 125, 1131, 1171 Oxide superconducting bulk body
115 Support member
120 Cooling device
121 Cold head
130 Heat insulating container
140 Magnetic field generating coil

## Claims

1. A magnet unit (110) for nuclear magnetic resonance, comprising:
a plurality of ring-shaped oxide superconducting bulk bodies (112) having a structure in which a RE₂BaCuO₅ phase is dispersed in a single-crystal REBa₂Cu₃O_{y} phase where RE is one or two or more elements selected from rare earth elements, and y satisfies 6.8 ≤ y ≤ 7.1,
wherein the plurality of oxide superconducting bulk bodies (112) are coaxially stacked in a coaxial direction to form a stacked body (111), and
the plurality of oxide superconducting bulk bodies (112) include
a first oxide superconducting bulk body (113) disposed at one end or both ends of the stacked body (111), and a second oxide superconducting bulk body (114) adjacent to the first oxide superconducting bulk body (113),
satisfy any one of the following conditions of A), B), A) and B), A) and C), B) and C), and A), B) and C):
A) an outer diameter (D_{QR}) of the first oxide superconducting bulk body (113) is smaller than an outer diameter (D_{QU}) of the second oxide superconducting bulk body (114),
B) a radial thickness of the first oxide superconducting bulk body is smaller than a radial thickness of the second oxide superconducting bulk body, and
C) a volume of the first oxide superconducting bulk body (113) is smaller than a volume of the second oxide superconducting bulk body (114).

2. The magnet unit (110) for nuclear magnetic resonance according to claim 1,
wherein the first oxide superconducting bulk body (113) satisfies all the conditions of A) to C).

3. The magnet unit (110) for nuclear magnetic resonance according to claim 1 or 2, further comprising:
a support member provided at least on an outer circumferential surface side of the first oxide superconducting bulk body (113) and on an outer circumferential surface side of the second oxide superconducting bulk body (114),
wherein a thickness of a portion of the support member located on the outer circumferential surface side of the first oxide superconducting bulk body (113) is larger than a thickness of a portion of the support member located on the outer circumferential surface side of the second oxide superconducting bulk body (114).

4. The magnet unit (110) for nuclear magnetic resonance according to claim 3,
wherein the support member extends so as to cover at least a part of an outer surface side end surface of the first oxide superconducting bulk body (113).

5. The magnet unit (110) for nuclear magnetic resonance according to any one of claims 1 to 4,
wherein an inner diameter of the first oxide superconducting bulk body (113) is 80% or more and 140% or less of an inner diameter of the second oxide superconducting bulk body (114).

6. The magnet unit (110) for nuclear magnetic resonance according to any one of claims 1 to 5,
wherein a corner portion formed by an outer surface side end surface and an inner circumferential surface of the first oxide superconducting bulk body (113) is chamfered.

7. The magnet unit (110) for nuclear magnetic resonance according to any one of claims 1 to 6,
wherein a plate-shaped oxide superconducting bulk body having the structure is disposed at the other end opposite to the one end where the first oxide superconducting bulk body (113) of the stacked body (111) is disposed.

8. A magnetic field generating device (10) for nuclear magnetic resonance comprising:
the magnet unit (110) for nuclear magnetic resonance according to claim 7; and
a cooling device having a low temperature portion,
wherein the plate-shaped oxide superconducting bulk body is connected to the low temperature portion.

## Patentansprüche

1. Magneteinheit (110) für Kernspinresonanz, aufweisend:
mehrere ringförmige oxidische supraleitende Volumenkörper (112) mit einer Struktur, in der eine RE₂BaCuO₅-Phase in einer einkristallinen REBa₂Cu₃O_{y}-Phase dispergiert ist, wobei RE für ein oder zwei oder mehr Elemente steht, das/die aus Seltene-Erden-Elementen ausgewählt ist/sind, und y die Beziehung 6,8≤y≤7,1 erfüllt,
wobei die mehreren oxidischen supraleitenden Volumenkörper (112) in einer koaxialen Richtung koaxial gestapelt sind, um einen gestapelten Körper (111) zu bilden, und
die mehreren oxidischen supraleitenden Volumenkörper (112)
einen ersten oxidischen supraleitenden Volumenkörper (113), der an einem Ende oder an beiden Enden des gestapelten Körpers (111) angeordnet ist, und einen zweiten oxidischen supraleitenden Volumenkörper (114) angrenzend an den ersten oxidischen supraleitenden Volumenkörper (113) aufweisen,
eine von den folgenden Bedingungen/Bedingungskombinationen erfüllen, nämlich Bedingung A), Bedingung B), die Bedingungen A) und B), die Bedingungen A) und C), die Bedingungen B) und C) und die Bedingungen A), B) und C), die wie folgt lauten:
A) ein Außendurchmesser (D_{QR}) des ersten oxidischen supraleitenden Volumenkörpers (113) ist kleiner als ein Außendurchmesser (D_{QU}) des zweiten oxidischen supraleitenden Volumenkörpers (114),
B) eine radiale Dicke des ersten oxidischen supraleitenden Volumenkörpers ist kleiner als eine radiale Dicke des zweiten oxidischen supraleitenden Volumenkörpers, und
C) ein Volumen des ersten oxidischen supraleitenden Volumenkörpers (113) ist kleiner als ein Volumen des zweiten oxidischen supraleitenden Volumenkörpers (114).

2. Magneteinheit (110) für Kernspinresonanz nach Anspruch 1,
wobei der erste oxidische supraleitende Volumenkörper (113) alle drei Bedingungen A) bis C) erfüllt.

3. Magneteinheit (110) für Kernspinresonanz nach Anspruch 1 oder 2, ferner aufweisend:
ein Trägerteil, das zumindest an einer Außenumfangsflächenseite des ersten oxidischen supraleitenden Volumenkörpers (113) und an einer Außenumfangsflächenseite des zweiten oxidischen supraleitenden Volumenkörpers (114) bereitgestellt ist,
wobei eine Dicke eines an der Außenumfangsflächenseite des ersten oxidischen supraleitenden Volumenkörpers (113) angeordneten Abschnitts des Trägerteils größer ist als eine Dicke eines an der Außenumfangsflächenseite des zweiten oxidischen supraleitenden Volumenkörpers (114) angeordneten Abschnitts des Trägerteils.

4. Magneteinheit (110) für Kernspinresonanz nach Anspruch 3, wobei das Trägerteil sich derart erstreckt, um mindestens einen Teil der Außenflächenseite-Endfläche des ersten oxidischen supraleitenden Volumenkörpers (113) zu bedecken.

5. Magneteinheit (110) für Kernspinresonanz nach einem der Ansprüche 1 bis 4,
wobei ein Innendurchmesser des ersten oxidischen supraleitenden Volumenkörpers (113) 80% oder mehr und 140% oder weniger als ein Innendurchmesser des zweiten oxidischen supraleitenden Volumenkörpers (114) ist.

6. Magneteinheit (110) für Kernspinresonanz nach einem der Ansprüche 1 bis 5,
wobei ein von einer Außenflächenseite-Endfläche und einer Innenumfangsfläche des ersten oxidischen supraleitenden Volumenkörpers (113) gebildeter Eckabschnitt abgeschrägt ist.

7. Magneteinheit (110) für Kernspinresonanz nach einem der Ansprüche 1 bis 6,
wobei ein plattenförmiger oxidischer supraleitender Volumenkörper mit der Struktur an dem anderen Ende angeordnet ist, das dem Ende gegenüberliegt, wo der erste oxidische supraleitende Volumenkörper (113) des gestapelten Körpers (111) angeordnet ist.

8. Magnetfelderzeugungsvorrichtung (10) für Kernspinresonanz, aufweisend:
die Magneteinheit (110) für Kernspinresonanz nach Anspruch 7; und
eine Kühlvorrichtung mit einem Niedertemperaturteil,
wobei der plattenförmige oxidische supraleitende Volumenkörper mit dem Niedertemperaturteil verbunden ist.

## Revendications

1. Unité d'aimant (110) pour résonance magnétique nucléaire, comprenant :
une pluralité de corps massifs d'oxyde supraconducteurs de forme annulaire (112) ayant une structure dans laquelle une phase de RE₂BaCuO₅ est dispersée dans une phase de REBa₂Cu₃O_{y} monocristalline, où RE est un ou deux ou plusieurs éléments choisis parmi des éléments de terre rare, et y satisfait à la relation 6,8 ≤ y ≤ 7,1.
dans laquelle la pluralité de corps massifs d'oxyde supraconducteurs (112) sont empilés coaxialement dans une direction coaxiale pour former un corps empilé (111), et
la pluralité de corps massifs d'oxyde supraconducteurs (112) comprennent
un premier corps massif d'oxyde supraconducteur (113) disposé au niveau d'une extrémité ou des deux extrémités du corps empilé (111), et un second corps massif d'oxyde supraconducteur (114) adjacent au premier corps massif d'oxyde supraconducteur (113),
satisfont à l'une quelconque des conditions suivantes de A), B), A) et B), A) et C), B) et C), et A), B) et C) :
A) un diamètre externe (D_{QR}) du premier corps massif d'oxyde supraconducteur (113) est plus petit qu'un diamètre externe (D_{QU}) du second corps massif d'oxyde supraconducteur (114),
B) une épaisseur radiale du premier corps massif d'oxyde supraconducteur est inférieure à une épaisseur radiale du second corps massif d'oxyde supraconducteur, et
C) un volume du premier corps massif d'oxyde supraconducteur (113) est inférieur à un volume du second corps massif d'oxyde supraconducteur (114).

2. Unité d'aimant (110) pour résonance magnétique nucléaire selon la revendication 1,
dans laquelle le premier corps massif d'oxyde supraconducteur (113) satisfait à toutes les conditions de A) à C).

3. Unité d'aimant (110) pour résonance magnétique nucléaire selon la revendication 1 ou 2, comprenant en outre
un élément support disposé au moins sur un côté de surface circonférentielle externe du premier corps massif d'oxyde supraconducteur (113) et sur un côté de surface circonférentielle externe du second corps massif d'oxyde supraconducteur (114),
dans laquelle une épaisseur d'une partie de l'élément support situé sur le côté de surface circonférentielle externe du premier corps massif d'oxyde supraconducteur (113) est supérieure à une épaisseur d'une partie de l'élément support situé sur le côté de surface circonférentielle externe du second corps massif d'oxyde supraconducteur (114).

4. Unité d'aimant (110) pour résonance magnétique nucléaire selon la revendication 3,
dans laquelle l'élément support s'étend de manière à couvrir au moins une partie d'une surface terminale de côté de surface externe du premier corps massif d'oxyde supraconducteur (113).

5. Unité d'aimant (110) pour résonance magnétique nucléaire selon l'une quelconque des revendications 1 à 4,
dans laquelle un diamètre interne du premier corps massif d'oxyde supraconducteur (113) est de 80 % ou plus et de 140 % ou moins d'un diamètre interne du second corps massif d'oxyde supraconducteur (114).

6. Unité d'aimant (110) pour résonance magnétique nucléaire selon l'une quelconque des revendications 1 à 5,
dans laquelle une partie coin formée par une surface terminale de côté de surface externe et une surface circonférentielle interne du premier corps massif d'oxyde supraconducteur (113) est chanfreinée.

7. Unité d'aimant (110) pour résonance magnétique nucléaire selon l'une quelconque des revendications 1 à 6,
dans laquelle un corps massif d'oxyde supraconducteur en forme de plaque ayant la structure est disposé au niveau de l'autre extrémité opposée à la première extrémité où le premier corps massif d'oxyde supraconducteur (113) du corps empilé (111) est disposé.

8. Dispositif générateur de champ magnétique (10) pour résonance magnétique nucléaire, comprenant :
l'unité magnétique (110) pour résonance magnétique nucléaire selon la revendication 7 ; et
un dispositif de refroidissement ayant une partie à basse température,
dans lequel le corps massif d'oxyde supraconducteur en forme de plaque est relié à la partie à basse température.
